# EUROPEAN PATENT SPECIFICATION

(11) **EP 4 302 156 B1**
(45) Date of publication and mention of the grant of the patent: **27.05.2026**
(21) Application number: 21711654.0
(22) Date of filing: 01.03.2021
(51) Int. Cl.: G03F 1/60, G03F 1/72, G03F 7/00

(54) **METHOD AND APPARATUS FOR OPTIMIZING A DEFECT CORRECTION FOR AN OPTICAL ELEMENT USED IN A LITHOGRAPHIC PROCESS**
VERFAHREN UND VORRICHTUNG ZUR OPTIMIERUNG EINER FEHLERKORREKTUR FÜR EIN OPTISCHES ELEMENT IN EINEM LITHOGRAPHISCHEN VERFAHREN
PROCÉDÉ ET APPAREIL POUR OPTIMISER UNE CORRECTION DE DÉFAUT POUR UN ÉLÉMENT OPTIQUE UTILISÉ DANS UN PROCESSUS LITHOGRAPHIQUE

(43) Date of publication of application: 10.01.2024
(73) Proprietor: Carl Zeiss SMS Ltd., 2015600 Misgav (IL)
(72) Inventor: DMITRIEV, Vladimir, 2010400 Tsurit (IL)
(74) Representative: Bardehle Pagenberg Partnerschaft mbB Patentanwälte Rechtsanwälte
(86) International application number: PCT/IL2021/050223
(87) International publication number: WO 2022/185298

(56) References cited:
- DE-A1- 102010 025 033
- US-A1- 2010 254 591
- US-A1- 2012 084 044
- US-A1- 2020 124 959

## Description

### 1. Field of the invention

The present invention relates to the field of optimizing a defect correction for an optical element used in a lithographic process.

### 2. Background of the invention

As a result of the constantly increasing integration density in the semiconductor industry, photolithographic masks and/or templates of the nanoimprint lithography have to project smaller and smaller structures onto a photosensitive layer, i.e. a photoresist dispensed on a wafer. To fulfil this demand, the exposure wavelength of photolithographic masks has been shifted from the near ultraviolet across the mean ultraviolet into the deep ultraviolet region of the electromagnetic spectrum. Presently, a wavelength of 193 nm is typically used for the exposure of the photoresist on wafers. As a consequence, the manufacturing of photolithographic masks with increasing resolution is becoming more and more complex, and thus more and more expensive as well. In near future, photolithographic masks will increasingly use significantly smaller wavelengths in the extreme ultraviolet (EUV) wavelength range of the electromagnetic spectrum (approximately 10 nm to 15 nm).

Therefore, photolithographic masks, photomasks or simply masks have to fulfil highest demands with respect to, for example, transmission homogeneity, planarity, pureness, and temperature stability. In order to fabricate photolithographic masks with a reasonable yield, defects or errors of masks cannot be excluded during the manufacturing process. These defects have to be corrected at the end of the manufacturing process. Various types of defects may occur. US 8 539 394 and US 10 061 192 describe methods for correcting overlay errors of various masks of a mask set. US 9 658 527 describes a mathematical physical model which can be used for determining arrangements of pixels which can correct various types of errors, as for example, registration errors, overlay errors, and/or optical transmission errors. US 9 753 366 describes a method for determining tool specific parameters of a tool which is used to write a pixel arrangement into an optical element calculated with the deformation model explained in US 9 658 527. US 8 735 030 describes a method for modifying a substrate surface by locally generating colour centers and/or writing arrangement(s) of pixels close to a distorted substrate surface. US 9 606 444 describes methods for locally deforming an optical element used for a photolithography process by designing specific pixels. US 10 353 295 describes a method for generating a predetermined three-dimensional contour of an optical element and/or a wafer.

DE 10 2010 025 033 A1 relates to a method for analyzing a defect of a photolithographic mask for the extreme ultraviolet (EUV) wavelength range (EUV mask) comprising the steps of: (a) generating at least one focus stack relating to the defect using an EUV mask inspection tool; (b) determining a surface configuration of the EUV mask at a position of the defect; (c) providing model structures having the determined surface configuration which have different phase errors and generating the respective focus stacks; and (d) determining a three dimensional error structure of the EUV mask defect by comparing the at least one generated focus stack of the defect and the generated focus stack of the model structures.

US 2020 / 0 124 959 A1 refers to a method and an apparatus for determining positions of a plurality of pixels to be introduced into a substrate of a photolithographic mask by use of a laser system, wherein the pixels serve to at least partly correcting one or more errors of the photolithographic mask. The method comprising the steps: (a) obtaining error data associated with the one or more errors; (b) obtaining first parameters of an illumination system, the first parameters determining an illumination of the photolithographic mask of the illumination system when processing a wafer by illuminating with the illumination system using the photolithographic mask; and (c) to determining the positions of the plurality of pixels based on the error data and the first parameters.

US 2010 / 0 254 459 A1 describes a method for verifying repairs on masks of photolithography. A mask based on a mask layout is inspected for defects, and the positions at which defects are found on the mask are stored in a position file. In a repair step, the defects are repaired and, for each defect position, in a verification step, an aerial image of the mask is taken at the position and the aerial image is analyzed to determine whether at the position the mask meets tolerance criteria established for the one or more selected target parameters, and if the tolerance criteria have been met, the repair is verified. The verification can include a) based on the position file, a desired structure is designed in the mask layout at the repaired position, b) an aerial image is simulated for the desired structure, c) the captured aerial image is compared with the simulated one, and d) based on the comparison, a decision is made as to whether the repair at the position is verified.

A relatively new type of lithography is the nanoimprint technique in which pattern elements are transferred via a polymer layer to an underlying wafer. Since the reproduction scale of pattern elements in a template for the nanoimprint lithography is 1:1, high demands are made to a template with respect to admissible errors. Thus, defective templates have also to be corrected whenever possible.

Femtosecond light pulses of a laser source can be used to correct errors of an optical element which can for example be a photolithographic mask, a template for the nanoimprint lithography and/or a wafer during its manufacturing process. For this purpose, the laser source applies a huge local energy density on the optical element, for example, a substrate of a photolithographic mask, a template or a wafer which leads to a local nonlinear ionization process resulting in a local plasma generation in the optical element. This local plasma generation induces a local variation of the density of, for example, the substrate or of the template material. A local density variation induced by an ultra-short light pulse is in the following also called a pixel. The introduction of a local density variation by locally applying the laser beam on the optical element is in the following denoted as the writing of pixels into the optical element. A cluster of pixels to be written or which has already been written into an optical element is called a pixel arrangement.

The writing of pixels into an optical element, for example to correct registration defects, locally changes the material density of the optical element. This results in a deformation of the optical element in three dimensions. The deformation in the x- and y-direction is mainly used for correcting registration defects. If pixels are written in a middle level of an optical element, for example a photomask, the global flatness of the photomask is not changed. However, pixels are often written in a plane which is close to the patterned surface of a mask to increase the spatial resolution of the pixel writing process. This modification of the process results in a global flatness change of the photomask, or generally of an optical element. This effect can be compensated by writing a second arrangement of pixels close to the rear surface of the mask. In this approach, errors in the writing depth of the pixel arrangement essentially impact the resulting flatness of the optical element.

This means the writing of pixels into an optical element, for example to correct registration defects, typically has two effects on a surface of the optical element: (a) It shifts pattern elements of the optical element towards their predetermined positions. This is a desired tangential surface deformation of the optical element. (b) But a pixel writing process also causes a second surface deformation which is normal to the local surface of the optical element. Typically, the normal surface deformation is an unwanted effect when correcting registration defects and/or overlay defects.

For modern lithography systems and in particular for future systems using the extreme ultraviolet (EUV) portion of the electromagnetic spectrum, the surface profile of the optical elements becomes critical. For example, half of a wavelength is only 6.75 nm for an exposure wavelength of 13.5 nm in the EUV wavelength range. The overall flatness budget for the individual optical elements used in a lithographic process is very tight. For example, registration and/or overlay error correction processes writing pixels in an optical element for the deep ultraviolet (DUV) wavelength range may not induce surface deformations larger than 30 nm.

This means that it is necessary to know the effect of the deformation a single pixel writing process induces in an optical element. But presently no model is available which is precisely enough to forecast the deformation of a pixel writing process based on the parameters of the laser system used for writing the pixel and the material parameters characterizing the optical element. Therefore, it is necessary to perform systematic calibration measurements to determine the changes the pixel causes in the optical element.

Calibration measurements can be done by direct registration change measurements. But registration measurements consume expensive patterned masks and require expensive metrology tools as well as complex logistics. For photomasks operating in the DUV wavelength range, birefringence measurements of optically transparent fused silica mask blanks can be used for calibration measurements. This approach is fast and cost-effective but does not allow direct deformation measurements. Furthermore, it requires some normalizations. Moreover, birefringence measurements cannot be used for calibrating EUV masks or EUV mask blanks.

It is therefore one object of the present invention to provide methods and apparatuses for optimizing a defect correction of an optical element which at least partially avoid the drawbacks discussed above.

### 3. Summary of the invention

According to a first aspect, a method according to claim 1 and an apparatus according to claim 18 are provided for solving the above problem at least partly. In a second aspect, a method according to claim 6 and an apparatus according to claim 19 are provided for optimizing a defect correction of an optical element used in a lithographic process.

In a first embodiment, a method for determining a writing depth of at least one pixel writing map written into an optical element used in a lithographic process from a surface contour deformation of the optical element comprises the steps: (a) determining a surface contour deformation induced by the at least one pixel writing map written into the optical element; (b) simulating at least two surface contour deformations of the at least one pixel writing map for at least two different writing depths, and (c) determining the writing depth of the at least one pixel writing map by comparing the determined surface contour deformation with the at least two simulated surface contour deformations.

A portion of the above-discussed drawbacks can be avoided if a relation can be established which links a surface contour deformation induced by a pixel writing process to the depth of an optical element into which of the pixels are generated. Such a relationship allows to calibrate the impact a pixel has on an optical element. Thus, establishing a relation between a pixel writing depth and a surface contour deformation complements calibration processes based on birefringence measurements and based on registration measurements for optical elements operating in the DUV wavelength range. As outlined above, for optical elements used in the EUV wavelength range, birefringence measurements of EUV mask blanks are virtually impossible. Further, registration measurements are involved, time consuming and thus cost intensive. Moreover, these measurements cannot be performed by the pixel writing tool. Rather, a time-consuming mask transport and an adjustment process has be performed on a respective metrology tool. Additionally, this calibration process consumes one or more wafers, and thus is a cost intensive approach.

Therefore, the knowledge of a relationship connecting an induced surface contour deformation with the pixel writing depth which can be used to reliably determine a writing depth, for example of an EUV substrate, from a determined surface contour deformation allows to partially avoid an experimental calibration of the pixel writing depth. Further, it enables verifying registration processes. Moreover, knowing the relation between the writing depth and the surface contour deformation allows a simultaneous tuning of registration problems, overlay problems and flatness problems. Thus, it allows to avoid the drawbacks outlined above to a large extent. What is more, such surface contour deformations may be determined with much less efforts than registration change and/or overlay change measurements.

A writing map or a pixel writing map is an arrangement of pixels or a pixel arrangement which is specifically designed for generating a surface contour deformation which can precisely be detected, and thus be utilized for establishing a reliable relationship between an induced surface contour deformation and the writing depth of the designed pixel writing map.

Determining the surface contour deformation may comprise:
(i) determining a surface contour of an initial optical element,
(ii) writing the at least one pixel writing map into the optical element,
(iii) determining a final surface contour after writing the at least one pixel writing map, and
(iv) determining the surface contour deformation by comparing the initial surface contour with the final surface contour.

A surface contour may be a flat surface of, for example, a photomask, a template used in nanolithography, a mirror, and/or a wafer. The flat surface may be a rear surface of a photomask, a template, a mirror, and/or a wafer. The surface contour of an optical element may be a curved surface of, for example, a lens or a curved surface of a mirror. The terms surface and surface contour are used interchangeably in this application.

A surface contour deformation of an optical element may be determined or measured by determining or measuring an initial surface contour, i.e. a surface prior to performing a pixel writing process or introducing a writing map into an optical element, and determining or measuring the surface contour resulting as a consequence of the generated writing map. The surface contour deformation may be determined by comparing the initial and the final surface contour, i.e. prior to and after the pixel writing.

An optical element may be a test optical element. For example, the test optical element may be a test photomask. The test mask may have a structured or patterned front surface which can be used to determine a tangential component of a surface deformation induced by a pixel writing process. A structured front surface of a test mask may have pattern elements of a photolithographic mask and/or marks for performing overlay adjustments in a photolithographic process.

The at least one pixel writing map may be adapted to an expected writing depth of the pixel writing map.

As already discussed above, the effect of a pixel depends on the depth it is written into an optical element. On the one hand, this correlation can be used for establishing a robust relation between a surface contour deformation and the writing depth of the pixel writing map. This relation can be used for correcting a determined or an identified surface contour deformation. Further, this connection may also be used for generating a predetermined surface contour starting from a determined or measured surface contour. Thus, knowing this relationship, allows designing optical elements having predetermined optical properties. This means, the typically unwanted effect of a surface contour deformation when correcting registration and/or overlay defects can be exploited for designing optical elements having specific optical characteristics.

On the other hand, the correlation between the writing depth and the surface contour deformation may also be utilized for designing a specific arrangement of pixels which corrects a defect of the optical element.

A high frequency content of a spatial spectral density of the at least one pixel writing map may decrease with an increasing expected writing depth of the at least one pixel writing map into the optical element.

The spatial frequency content transmitted by an arrangement of pixels to a surface of the optical element may be understood as a function of the pixel writing depth. This relationship can be exploited when designing pixel writing maps for determining the implication of a pixel writing process on the induced surface contour deformation.

The at least one pixel writing map may not be written in a writing depth within a range around a depth center of the optical element of ±20 µm, preferably ±50 µm, more preferably, ±100 µm, and most preferably ±200 µm. For example, if the optical element has a depth of 10 mm, its depth center is 5 mm.

Writing pixels into the center depth which is half the depth of the optical element has a minimum effect on the surface contour of the surface through which the pixel writing map in introduced and also on the surface opposite to the surface used for the pixel writing process. When it is the objective to set-up a relation between the writing depth and the surface contour deformation, it is beneficial to exclude this range from measurement, since it is difficult to interpret the respective measurements.

The at least one pixel writing map may have a distance from a front surface and a rear surface of the optical element which is > 20 µm, preferably > 30 µm, more preferred > 50 µm, and most preferred > 80 µm.

Excluding this range from pixel writing may secure that the respective surface of the optical element is not damaged by the huge optical intensities typically used in a pixel writing process.

If the optical element comprises a photolithographic mask, a pixel writing map has a distance to the patterned front surface of > 100 µm, preferably > 150 µm, more preferred 200 µm, and most preferred > 250 µm, and/or the pixel writing may have a distance to the rear surface of > 20 µm, preferably > 30 µm, more preferred > 50 µm, and most preferred > 80 µm. In case the optical element is an EUV mask having a rear side coating, a safety distance to the coated surface of 500 µm or more is typically used to avoid damaging the rear side coating.

Determining the surface contour deformation may comprise defining a grid across a surface of the optical element the at least one pixel writing map is introduced into and/or the surface of which the surface contour deformation is to be determined and determining the surface contour at the grid nodes.

Determining the surface contour deformation may comprise determining a difference between the initial and the final surface contour at the grid nodes, squaring the differences of the grid nodes, and adding the squared differences of the grid nodes. It is also possible to add the absolute values of the of the measured differences of the various grid nodes.

Simulating the surface contour deformation may comprise using a three-dimensional deformation model of the optical element.

A three-dimensional (3D) deformation model interconnects an induced tangential modification which, for example, shifts or displaces pattern elements on the surface of a photomask with an induced normal modification which typically results in a surface contour modification.

The three-dimensional deformation model may use material parameters of the optical element, parameters specific for a tool writing the at least one pixel writing map, and basic physical laws. An exemplary 3D deformation model is explained in detail in the US patent US 9 658 527.

Step c. of claim 1 may further comprise determining tool specific parameters of a three-dimensional deformation model and the writing depth of the at least one pixel writing map in a common fitting process.

This approach minimizes the expense for setting up a relation between determined surface contour deformations and the writing depth of the writing map.

Determining tool specific parameters of the three-dimensional deformation model may comprise using at least one of: a registration measurement, an overlay measurement, an optical transmission measurement, and a birefringence measurement of the optical element.

In an alternative approach, the tool specific parameters may be obtained by performing a separate measurement. For example, optical transmission measurements and/or birefringence measurements of the optical element may be performed by the pixel writing tool or by a metrology tool which is close by the pixel writing tool. Registration measurements and/or overlay measurements typically require one or more wafer exposures and the detection of the wafer exposure with a separate metrology tool. Hence, the determination of the tool specific parameters is a rather complex and cost intensive process when the exposure of wafer(s) and/or test structures is involved.

The tool specific parameters may have at least two specific manifestations, namely as an expansion signature (ES) or as a mode signature (MS). The expansion signature is a three-dimensional (3D) deformation caused by one pixel of a specific pixel type written into a predetermined depth of an optical element. The mode signature specifies the reduction of the optical intensity transmitted through an optical element having a specific pixel type in a predetermined depth referred to one pixel of the specific pixel type. The parameter MS is relevant for transmissive optical elements, as the variation of the optical transmission is important. The ES is normalized to the pixel density, i.e. number of pixels per square millimeter. The ES is the more relevant parameter for EUV optical elements where the optical property of the pixel writing process is of less importance.

Both, the ES and the MS are conventionally determined by writing specific arrangements of pixels into a test optical element, determining or measuring the resulting effect and normalizing the obtained result to one pixel.

The determined writing depth is the depth into which the at least one pixel writing map is introduced in the optical element which minimizes a difference between the determined surface contour deformation and one of the at least two simulated surface contour deformations.

Simulating the surface contour deformation may comprise simulating the surface contour deformation at three or more writing depths of the at least one pixel writing map, and/or may comprise determining the writing depth by interpolating between the simulated surface deformations having the two lowest differences to the determined surface contour deformation.

Determining the writing depth may comprise fitting the three or more simulated surface contour deformations with a polynomial for determining the writing depth which minimizes a mismatch between the determined surface contour deformation and the simulated surface contour deformations.

This additional simulation step may increase the accuracy with which the writing depth can be obtained.

As already discussed above, at least a portion of the optical element is optically transmissive for the tool writing the at least one pixel writing map in the optical element. For example, if the optical element is a photomask, the substrate of the photomask is at least partially optically transparent to the wavelength of the laser writing the pixels. The writing tool for the at least one pixel writing map may comprise a laser system generating ultra-short light pulses. The wavelength of the pixel writing tool may be adapted to a material of the optical element.

A computer program may have instructions for causing a computer system to perform any of the method steps of any of the aspects described above when the computer system executes the computer program.

In a second embodiment, a method for optimizing a defect correction of an optical element used in a lithographic process comprises the steps: (a) determining whether the optical element has at least one defect; (b) determining whether the optical element has at least one surface contour deformation; and (c) determining at least one pixel arrangement for writing into the optical element based on whether at least one defect has been determined and on whether at least one surface contour deformation has been determined, the at least one pixel arrangement correcting the at least one defect, the at least one surface contour deformation or both.

In a conventional defect correction procedure, an identified defect is corrected. Then it is detected whether the executed correction process has induced an inadmissible change of a quantity of the optical element. If this is the case, the quantity of the optical element which is out of specification is corrected in a second correction step.

The method of the second embodiment allows to perform a defect correction process in such a way that it does essentially not induce any detrimental effect on the optical element. This beneficial effect is achieved by designing a defect correction process that simultaneously corrects a defect and a surface contour deformation. In this way, the method may optimize the defect correction of an optical element. A first special or limiting case is defined above in the context of the first embodiment. The method comprises a second special case which is correcting a defect of the optical element without inducing any surface contour deformations. The general case is between these two special cases and allows a simultaneous correction of one or more defects and one or more surface contour deformations.

The method may further comprise the step of writing the at least one pixel arrangement into the optical element. A pixel writing tool may write the at least one pixel arrangement into the optical element.

Writing the at least one pixel arrangement may comprise at least one of:
(i) correcting the at least one defect without introducing a surface contour deviation, if at least one defect is determined in step a. and if no surface contour deformation is determined in step b.,
(ii) correcting the at least one surface contour deformation, if at least one surface contour deformation is determined in step b. and if no defect is determined in step a., and
(iii) simultaneously correcting the at least one defect and the at least one surface contour deformation, if at least one defect is determined in step a. and at least one surface contour deformation is determined in step b.

The at least one defect may comprise at least one of: at least one placement defect of at least one pattern element of a photolithographic mask, at least one overlay defect of a photolithographic mask, at least one phase shifting defect of a photolithographic mask, at least one optical transmission defect of a transmissive photolithographic mask, at least one absorber defect and/or at least one phase defect of a reflective photolithographic mask, at least one placement defect of a template used in a nanolithography process, and at least one placement defect and/or at least one optical transmission defect of a wafer during a manufacturing process.

The pattern element may comprise at least one of: an absorbing pattern element, a phase shifting pattern element, and/or an absorbing and phase shifting pattern element.

The optical element may comprise at least one of: a photolithographic mask, a template for the nanoimprint lithography, a mirror and/or a lens used in a photolithographic exposure system, a mirror and/or a lens used in a photolithographic exposure system, and a wafer. The photolithographic mask may be a transmissive mask, a reflective mask, or a mask used in double or multi patterning processes. Further, the photolithographic mask may be of any patterning type, for example, having absorbing pattern elements, phase shifting pattern elements, and/or absorbing and phase shifting pattern elements.

The template may be a template used in any type of nanoimprint lithography, as for example, thermoplastic nanoimprint lithography, photo nanoimprint lithography or resist-free direct thermal nanoimprint lithography.

A wafer may be of any semiconductor material, as for example silicon or germanium, or any compound semiconductor material, as for example, gallium arsenide (GaAs), indium phosphide (InP) or gallium nitride (GaN) to just name a few.

A surface contour deformation may comprise a deviation between a determined surface contour and a predetermined surface contour. A determined surface contour may be a measured surface contour. A predetermined surface contour may be surface contour predetermined by the design of the optical element.

The method may further comprise:
(i) in step a. measuring data of the at least one defect and/or obtaining data of the at least one defect, and/or
(ii) in step b. measuring data for determining the at least one surface contour deformation, and/or obtaining data for determining the at least one surface contour deformation.

The method may be executed in a stand-alone computing unit specifically designed for determining at least one pixel arrangement based on data of at least one defect and/or at least one surface contour deformation. It is also possible to integrate the computing unit into a metrology tool used for determining whether the optical element has at least one defect, to integrate the computing unit in a metrology tool used for determining whether the optical element has at least one surface contour deformation, or to integrate the computing unit in a tool used for writing the at least one pixel arrangement into the optical element.

Obtaining data of the at least one defect and/or obtaining data for determining the at least one surface contour deformation may comprise at least one of: loading the data from a memory, and receiving the data from at least one metrology tool.

Determining the at least one surface contour deformation may comprise using at least one of: one or more confocal microscopes, one or more probes of a scanning probe microscope, one or more capacitive distance gauges, an electron beam of a scanning electron microscope, one or more photomask metrology tools, one or more contact profilometers, one or more pseudo-contact profilometers, one or more non-contact profilometers, one or more interferometers, and one or more white light interferometers.

Determining the at least one defect may comprise using at least one of: a registration measuring tool, an overlay measuring tool, an optical transmission measuring tool, an optical reflection measuring tool, and a phase measuring tool. The registration measuring tool and/or the overlay measuring tool may comprise a scanning particle beam microscope and/or a scanning probe microscope.

Determining the at least one pixel arrangement may comprise adapting the spatial frequency content of the at least one pixel arrangement to the determined writing depth of the at least one pixel arrangement.

Determining the at least one pixel arrangement may comprise determining a writing depth of the at least one pixel arrangement.

This approach allows to adapt a spatial frequency content of the at least one pixel arrangement to the depth into which the at least one pixel arrangement is generated. The simultaneous determination of the writing depth and the pixel arrangement enables an optimal adaption of both for the task of simultaneously correcting one or more defects and one or more surface contour deformations of an optical element.

Determining the at least one pixel arrangement may comprise using a three-dimensional deformation model parameterized for the optical element.

Determining the at least one pixel arrangement may comprise determining tool-specific parameters of a three-dimensional deformation model for the tool used for writing the at least one pixel arrangement into the optical element.

Determining tool specific parameters of the three-dimensional deformation model may comprise determining the writing depth of the at least one pixel arrangement and the tool specific parameters in a common fitting process.

Applying a common fitting process for determining the writing depth as well as the tool specific parameters minimizes the effort for the determination of the at least one pixel arrangement. For example, US 9 753 366 discusses a method for determining tool specific parameters of a tool used for introducing a pixel arrangement calculated by means of a 3D deformation model into an optical element.

Determining tool specific parameters of the 3D deformation model may comprise performing at least one of: a registration measurement of the optical element, a birefringence measurement of the optical element, an optical transmission measurement, an overlay measurement, and a measurement for determining a surface contour deformation as a function of the writing depth of a pixel writing map. The last item is discussed when describing the first embodiment.

The at least one pixel arrangement may comprise a two-dimensional layer of pixels which is written parallel to the surface of the optical element through which the at least one pixel arrangement is written into the optical element.

The surface through which the at least one pixel arrangement is introduced into an optical element is in the following also called rear side or back side of the optical element. For example, if the optical element is an EUV mask, the rear side is the substrate side typically having an electrically conductive coating. The front or front side is the side of a mask which has the mask pattern.

Determining the at least one pixel arrangement may comprise determining a writing depth for the at least one pixel arrangement. A 3D deformation model enables to calculate both the tangential and the normal surface changes caused by the generation of one pixel. Thus, the 3D deformation model is the basis for the determination or calculation of one or more pixel arrangements to be introduced into the optical element.

Determining the at least one pixel arrangement may comprise determining at least one pixel type used in the at least one pixel arrangement. A pixel type is characterized by the parameters of the pixel writing tool. The pixel writing tool is typically a laser system which can generate ultra-short laser pulses. The pixel writing tool may generate a pixel focusing a single ultrashort light pulse to a specific position within the optical element.

It is also possible to generate a pixel by subsequentially applying two or more light pulses onto the same position of the optical element. A pixel writing tool may comprise a laser system. A relation connecting the writing depth of the at least one pixel arrangement with the surface contour deformation induced by the at least one pixel arrangement - as discussed above - may be used to facilitate the determination e the at least one pixel arrangement.

The wavelength of the pixel writing tool may be adapted to the band gap of the optical element. Typically, a writing wavelength is in the infrared (IR), the visible or the ultraviolet (UV) range of the electromagnetic spectrum. A pixel type may be characterized by a pulse energy, a pulse length, a repetition rate, a numerical aperture (NA) of the objective focusing the light pulses into the optical element, a beam polarization, wavefront determining parameters of the beam, as an astigmatism, a defocus, a trefoil and higher order distortions, a beam intensity distribution, and a beam spectrum (wavelength).

Determining the at least one pixel arrangement may comprise determining a two-dimensional (2D) pixel density used in the at least one pixel arrangement. The 2D pixel density is a lateral distance (i.e. normal or perpendicular to the beam direction) between two pixels.

Determining the at least one pixel arrangement may comprise determining a varying two-dimensional pixel density within the at least one pixel arrangement. The pixel density may vary in one direction or in two directions. Further, the pixel density may vary differently in two directions.

The at least one pixel arrangement may comprise at least two pixel layers written into different depths. The difference in the depth between the at least two pixel layers of the at least one pixel arrangement may be larger than a dimension of the pixels within a layer. This means the pixels in the various layers of the pixel arrangement do not overlap or merge. The at least two pixel layers within the at least one pixel arrangement may be parallel. The pixel type and the pixel density within the at least two different layers may be different. Further, the pixel types may be different within the at least two different layers of the at least one pixel arrangement.

The method may further comprise the step of determining the surface contour deformation of the optical element after writing the first pixel layer of the at least one pixel arrangement.

Moreover, the method may further comprise the step of adapting the at least one second pixel layer of the at least one pixel arrangement to the determined surface contour deformation.

In the general case, if the at least one pixel arrangement has N pixel layers, at least the (i+1)^{th} pixel layer of the at least one pixel arrangement of the remaining (N-i) pixel layers to be written into the optical element is adapted to the surface contour deformation determined or measured after writing the i^{th} pixel layer of the at least one pixel arrangement.

It is a beneficial effect of the present application that a pixel writing process may be interrupted after the introduction of a first pixel layer (generally an i^{th} pixel layer) and the surface contour deformation induced by the writing process of the first (generally first to i^{th}) pixel layer can be determined. Then one, several or all of the (N-i) pixel layers of the at least one pixel arrangement remaining to be written into the optical element can be adapted to the currently measured surface contour deformation or may be newly calculated. This means that the method may be performed as an iterative process. The correction of a defect, of a determined surface contour deformation or of both can be controlled during the correction process. If the correction process runs out of a specified range, one or several of the pixel layers remaining to be written can be corrected so that the correction process is brought back on track. The knowledge of the relationship between a surface contour deformation induced by a pixel layer and its writing depth can be used when adapting the pixel layers remaining to be written into the optical element of the pixel arrangement to a detected defect rest and/or a determined surface contour deformation.

It is an optimizing effect of the method described in this application that a closed feedback loop can be set up for a defect correction process of an optical element that allows a constant adaption to the progress of the defect correction. This enables to perform a defect correction of an optical element in a single process and simultaneously secures that no other characteristics of the optical element runs out of a predetermined specification.

The at least one pixel arrangement may comprise 1 to 50, preferably 2 to 25, more preferred 3 to 14, and most preferred 4 to 8 pixel layers written into different depths of the optical element.

Adapting the at least one pixel arrangement to the determined surface contour deformation may comprise adapting at least one of: a pixel type, a two-dimensional pixel density, the writing depth of the at least one second layer of the pixel arrangement, introducing and/or adapting a sub-structure of the at least one second pixel layer, and a size of the least one second pixel layer of the at least one pixel arrangement.

Determining the at least one pixel arrangement may comprise determining a minimum distance of the at least one pixel arrangement from a front surface and/or a rear surface of the optical element.

The determination of the minimum distance of the at least one pixel arrangement to the front and/or rear surface of the optical element can be performed by using the 3D deformation model. By not generating pixels within the minimum distance secures that the front surface and/or the rear surface of the optical element may not be damaged.

In contrast to the first embodiment, it may be beneficial to write the at least one pixel arrangement or at least a portion thereof close to the center depth of the optical element. By writing pixels in the center depth of the optical element, the effect of the normal component of the induced surface modification is minimized. Thus, the ratio of the induced tangential and normal surface modifications is maximized. The relationship between the induced surface contour deformation and the writing depth set up in the first embodiment can be used to determine the optimum writing depth.

The at least one pixel arrangement may have a distance to a front surface and/or a rear surface of the optical element > 20 µm, preferably > 30 µm, more preferred > 40 nm, and most preferred > 50 µm.

In case the optical element comprises a photolithographic mask, a pixel writing map has a distance to the patterned front surface of > 100 µm, preferably > 150 µm, more preferred 200 µm, and most preferred > 250 µm, and/or the pixel writing may have a distance to the rear surface of > 20 µm. preferably > 30 µm, more preferred > 50 µm, and most preferred > 50 µm. In case the optical element is an EUV mask having a rear side coating, a safety distance to the coated surface of 500 µm or more is typically used to avoid damaging the rear side coating.

A distance between the at least two layers of the at least one pixel arrangement may be larger than a pixel dimension parallel to a writing direction of the pixels in the at least two layers of the at least one pixel arrangement. This means the pixels between two of the two or more pixel layers do not overlap or merge. Therefore, the effect of the two or more generated pixel layers is linear and additive. The writing direction may be perpendicular to the rear surface and/or the front surface of the optical element.

An optical element may be manufactured according to a method of any one of the aspects of the second embodiment.

In a first embodiment, an apparatus for determining a writing depth of at least one pixel writing map written into an optical element used in a lithographic process from a surface contour deformation of the optical element comprises: (a) means for determining a surface contour deformation induced by the at least one pixel writing map written into the optical element; (b) means for simulating at least two surface contour deformations of the pixel writing map for at least two different writing depths, and (c) means for determining the writing depth of the at least one pixel writing map by comparing the determined surface contour deformation with the at least two simulated surface contour deformations.

The means of simulating at least two surface contour deformations may comprise a computing unit adapted to use a 3D deformation model for simulating surface contour deformations induced by a pixel writing map introduced in at least two different depths of the optical element.

The apparatus may further comprise means for writing the pixel writing map into the optical element.

In a second embodiment, an apparatus for optimizing a defect correction of an optical element used in a lithographic process comprises: (a) means for determining whether the optical element has at least one defect; (b) means for determining whether the optical element has at least one surface contour deformation; and (c) means for determining at least one pixel arrangement for writing into the optical element based on whether at least one defect has been determined and on whether at least one surface contour has been determined, the at least one pixel arrangement correcting the at least one defect, the at least one surface contour deformation or both.

The apparatus may comprise means for writing the at least one determined pixel arrangement into the optical element. The means for determining the at least one pixel arrangement may comprise a computing unit.

A computer program may have instructions for causing a computer system to perform any of the method steps of any of the aspects described above with respect to the second embodiment when the computer system executes the computer program.

### 4. Description of the drawings

In order to better understand the present invention and to appreciate its practical applications, the following figures are provided and referenced hereafter. It should be noted that the figures are given as examples only and in no way limit the scope of the invention.
- Fig. 1: schematically depicts a cross-sectional view of a confocal microscope for determining a surface contour of an optical element;
- Fig. 2: schematically represents a block diagram of an apparatus used for generating pixels in an optically transparent material of an optical element;
- Fig. 3: schematically represents an apparatus which combines the confocal microscope of Fig. 1, the pixel writing tool of Fig. 2 and a computing unit;
- Fig. 4: schematically depicts an apparatus which combines the confocal microscope of Fig. 1 and the pixel writing tool of Fig. 2;
- Fig. 5: schematically shows a cross-section of a photomask for the extreme ultraviolet (EUV) wavelength range having a surface contour deformation of its rear surface and a registration defect on its front surface;
- Fig. 6a: schematically depicts a cross section of a test mask for the deep ultraviolet (DUV) wavelength range in which a pixel writing map is written in a depth of 5080 µm, the pixel writing map is given in Fig. 6b;
- Fig. 6b: schematically depicts the pixel writing map introduced in the DUV test mask of Fig. 6a;
- Fig. 7: schematically presents the measured registration change induced by the pixel writing map of Fig. 6b;
- Fig. 8: schematically depicts the simulated registration change for determining the tool specific expansion signature (ES) parameters;
- Fig. 9: schematically presents with enlarged scale a remaining mismatch of the measured registration change of Fig. 7 and the simulated registration change of Fig. 8;
- Fig. 10: schematically shows the surface contour deformation of the front surface of the DUV test mask of Fig. 6a and 6b induced by the pixel writing map of Fig. 6b;
- Fig. 11: schematically represents the remaining mismatch between the measured surface contour deformation of Fig. 10 and a simulated surface contour deformation;
- Fig. 12: schematically depicts table 1 which summaries the results of the ES parameter determination on the basis of measured registration data, measured surface contour deformation data and measured birefringence data of the DUV test mask of Fig. 6a and 6b;
- Fig. 13: presents a remaining mismatch between the measured surface contour deformation of Fig. 10 and simulated surface contour deformations for various writing depths of the pixel writing map indicated in Fig. 6b;
- Fig. 14a: shows a remaining mismatch between the measured surface contour deformation of Fig. 10 and simulated surface contour deformations for various writing depths of the pixel writing map indicated in Fig. 6b for simultaneously determining the writing depth and the tool specific ES parameters of the 3D deformation model;
- Fig. 14b: presents Fig. 14a with an enlarge section of the ordinate;
- Fig. 15: schematically depicts a pixel writing map of the DUV test mask of Fig. 6a;
- Fig. 16a: presents the remaining mismatch between a measured surface contour deformation and simulated surface contour deformations for various writing depths of the pixel writing map of Fig. 15 for simultaneously determining the writing depth and the tool specific ES parameters of the 3D deformation model;
- Fig. 16b: reproduces Fig. 16a with an enlarged section of the ordinate;
- Fig. 17: schematically represents a third example of a pixel writing map of the DUV test mask of Fig. 6a, the pixel writing map is introduced into a depth of 5080 µm having an increased ratio of circumference to area (compared to the pixel writing maps of Fig. 6b and 15);
- Fig. 18a: depicts the remaining mismatch between a measured surface contour deformation and simulated surface contour deformations for various writing depths of the pixel writing map indicated in Fig. 17 for simultaneously determining the writing depth and the tool specific ES parameters of the 3D deformation model;
- Fig. 18b: reproduces Fig. 18a with an enlarged section of the ordinate;
- Fig. 19: schematically shows a fourth example of a pixel writing map of the DUV test mask of Fig. ta, the pixel writing map is introduced into a depth of 1250 µm having an increased content of high spatial frequencies (compared to the pixel writing maps of Fig. 6b, 15 and 17);
- Fig. 20a: presents the remaining mismatch between a measured surface contour deformation and simulated surface contour deformations for various writing depths of the pixel writing map of Fig. 17 for simultaneously determining the writing depth and the tool specific ES parameters;
- Fig. 20b: reproduces Fig. 20a with an enlarged section of the ordinate;
- Fig. 21a: schematically depicts a cross section of the test mask of Fig. 6a having a pixel writing map written into a depth which is different from the one of Fig. 6a;
- Fig. 21b: presents a pixel arrangement or pixel writing map calculated for correcting registration defects of the test mask of Fig. 21a;
- Fig. 22a: shows a simulated surface contour deformation induced by the pixel arrangement of Fig. 21b;
- Fig. 22b: depicts the measured surface contour deformation induced by the pixel arrangement of Fig. 21b;
- Fig. 22c: presents the remaining difference when subtracting the surface contour deformation of Fig. 22b from the surface contour deformation of Fig. 22a;
- Fig. 23a: represent registration defects defined for a hypothetic mask which has also a surface contour deformation;
- Fig. 23b: shows the surface contour deformation defined for the mask of Fig. 23a having also registration defects;
- Fig. 24a: shows the remaining registration defects after performing a registration correction process which does not consider the surface contour deformation of the mask;
- Fig. 24b: depicts the surface contour deformation contribution induced by the registration correction process of Fig. 24a;
- Fig. 24c: presents the sum of the initial surface contour deformation of the mask of Fig. 23b and the contribution added by the registration correction process depicted in Fig. 24a;
- Fig. 25a: shows the remaining registration defects after performing a registration correction process which simultaneously corrects the surface contour deformation of Fig. 23b;
- Fig. 25b: depicts the surface contour deformation induced by the registration correction process of Fig. 25a;
- Fig. 25c: presents the remaining surface contour deformation after performing the registration correction process of Fig. 25a;
- Fig. 26: presents a flow chart of a method for determining a writing depth of a t least one pixel writing map which is written into an optical element used in a lithographic process from a surface contour deformation; and
- Fig. 27: depicts a flow diagram of a method for optimizing a defect correction of an optical element used in a lithographic process.

### 5. Detailed description of preferred embodiments

In the following, the present invention will be more fully described hereinafter with reference to the accompanying figures, in which exemplary embodiments of the invention are illustrated. However, the present invention may be embodied in different forms and should not be construed as limited to the embodiments set forth herein. Rather, these embodiments are provided so that this disclosure will be thorough and will convey the scope of the invention to persons skilled in the art.

In the following, the present invention is described by taking photolithographic masks as examples. However, the present invention can also be applied to optical elements, in particular to optical elements used in various kinds of lithographic systems, as for example, photolithographic exposure systems and nanolithography systems. Apart from photomasks and templates, optical elements in form of, for example, mirrors, lenses, and wafers can be also be corrected with the methods described in this application to just mention a few examples. Further, the operation wavelength range of the optical elements is not restricted to the wavelengths used in lithography systems. Rather, the optical elements processed with the methods can be used across the entire optical range. Moreover, the present invention is not restricted to semiconductor wafers, as for example silicon or germanium wafers. Rather, they can be applied to all kind of wafers used for fabricating any kind of integrated circuits.

Finally, the methods defined above can be applied to all optical elements whose materials are at least partially optically transparent for a specific wavelength range of the electromagnetic spectrum. If a material of an optical element fulfils this requirement, pixels can be introduced into the material of the optical element. It is presently preferred that the transparent wavelength range of a material of an optical element is in the ultra-violet (UV), the visible and/or the infrared (IR) part of the electromagnetic spectrum as numerous laser sources are available for these spectral ranges.

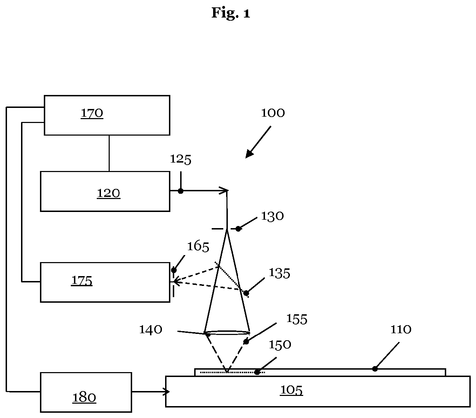

Fig. 1 schematically illustrates an example of a metrology tool 100 which can be used to determine a two-dimensional (2D) or a 3D image or a surface contour of an optical element. The confocal microscope 100 of Fig. 1 is only an example of a class of metrology tools which can be applied to measure the surface contour of an optical element. For examples, a profilometer or an interferometer can also be used to analyse a surface profile or a surface contour of an optical element.

In the following, the operational principle of a confocal sensor 100 or a confocal microscope 100 is outlined. A confocal microscope 100 uses a point illumination of a pinhole in an optically conjugate plane in front of a detector to eliminate out-of-focus signal components. In the example of Fig. 1, the point illumination is generated with a light source 120, an optical fiber 125 which couples the light of the light source 120 through the pinhole 130 via the objective 140 into a focal plane 150 of a photomask 110. Light reflected from the focal plane 150 is directed to the pinhole 165 by a dichroic mirror 135 which is arranged in front of the detector 175. The portion of light which is reflected from outside of the focal plane 150 is significantly smaller than light reflected from the focal plane 150. Furthermore, light reflected from outside the focal plane 150 is not focussed onto the pinhole 165.

For example, the light source 120 may be a laser source. If an optical fiber 125 is used for guiding the electromagnetic radiation from the light source 120 to the pinhole 130, the pinhole 130 may be omitted as the fiber 125 has a similar effect as the pinhole 130. The detector 175 may for example be a photodiode, an avalanche photodiode, or a photomultiplier.

A photomask 110 or generally an optical element 110 may be arranged on a sample stage 105. The sample stage 105 may be movable and is moved by a scan unit 180 in a plane which is perpendicular to the incident light beam (x- and/or y-direction). For example, micromanipulators or servomotors can be used for moving the sample stage 105 (not shown in Fig. 1). By moving the sample stage 105 parallel to the beam direction and/or by shifting the objective 140, the focal plane can be scanned through the optical element 110. In an alternative implementation, the sample stage 105 is fixed and the light beam 155 is scanned across the photomask 110. This implementation is called confocal laser scanning microscope (CLSM) (not depicted in Fig. 1).

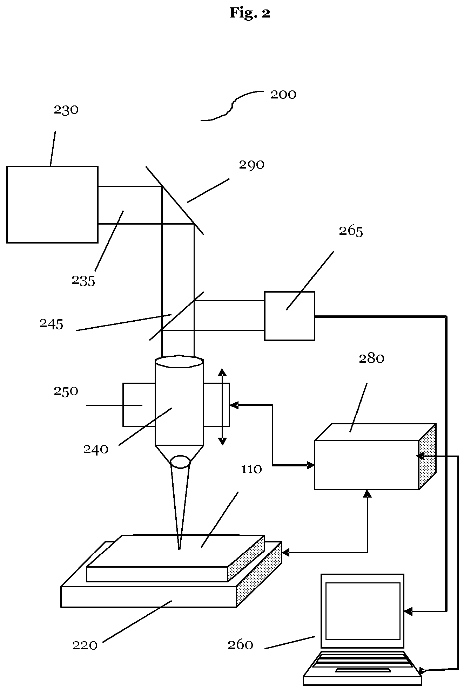

A control unit 170 controls the light source 120, the detector 175 as well as the scan unit 180. It is also possible that the control unit 170 controls the movement of the objective 140 (not shown in Fig. 1). Further, the control unit 170 may be embedded in a computer system having at least a processor, a storage unit, I/O (input/output) unit(s), and a display (not represented in Fig. 1). The control unit 170 or the computer system stores data received from the detector 175. Moreover, a processing unit of the control unit 170 or the processor of the computer system (also not shown in Fig. 1) are able to process the measurement data of the detector 175. Finally, the control unit 170 or the computer system 170 may have a connection to the apparatus 200 of Fig. 2 to transmit the measured and/or the processed data to the apparatus 200.

The resolution of the confocal microscope 100 in lateral direction is limited by diffraction. This means that the lateral resolution depends on the diameter or opening of the pinholes 130 and 165, the numerical aperture (NA) of the objective 140 as well as on the wavelength of the light source 120. In lateral direction, the resolution is in the range of the wavelength of the light source 120. The resolution in the beam direction is not diffraction limited but limited by the determination of the position of the maximum intensity. The resolution in beam direction reaches the one-digit nanometer range.

Fig. 2 depicts a schematic block diagram of an apparatus 200 which can be used to calculate or determine and/or to write a pixel writing map and/or a pixel arrangement into an optical element 110. The principle is illustrated for the example of a photomask. Other examples of optical elements 110 may be templates used in the nanoimprint technique, lenses and/or mirrors of a lithographic system. Further examples are wafers for fabricating integrated circuits (ICs). Details of generating pixel arrangements in wafers are discussed in US 10 353 295.

The apparatus 200 comprises a chuck 220 which may be movable in three dimensions. The optical element 110, for example a mask 110, may be fixed to the chuck 220 by using various techniques as for example clamping. The photolithographic mask 110 may be a transmissive mask mounted upside down, so that its rear substrate surface is directed towards the objective 240.

The apparatus 200 includes a pulse laser source 230 which produces a beam or a light beam 235 of pulses or light pulses. The laser source 230 generates light pulses of variable duration. The pulse duration may be as low as 10 fs but may also be continuously increased up to 100 ps. The pulse energy of the light pulses generated by the pulsed laser source 230 can also be adjusted across a huge range reaching from 0.001 µJ per pulse up to 10 mJ per pulse. Further, the repetition rate of the light pulses comprises the range extending from 1 Hz to 100 MHz. In an example, the light pulses may be generated by a Ti:sapphire laser operating at a wavelength of about 800 nm. However, the methods described in the following are not limited to this laser type, principally all laser types may be used having a photon energy which is smaller than the band gap of the optical element 110 and which are able to generate ultra-short pulses with durations in the femtosecond range. This criterion also holds for wafers. Generally, the emission wavelength of the apparatus 200 has to be adapted the band gap of the optical element 110.

Therefore, for example, YAG laser systems doped with at least one of the elements neodymium (Nd), thulium (Tm), holmium (Ho), and erbium (Er) can also be used. As a further example, dye laser systems may also be applied. The apparatus 200 may also comprise more than one pulse laser source 230 of the same type or of different types (not shown in Fig. 2).

The requirement that the band gap of the optical element 110 is larger than the emission wavelength of the laser source used to apply ultra-short laser pulses is typically equivalent to the requirement that the optical element 110 is optically transparent in the near-infrared, the visible, and/or the near-ultraviolet wavelength range. In these wavelength ranges, laser sources are available which can generate ultra-short pulses having a large energy density in their focus.

The following table represents an overview of an example of laser beam parameters of a frequency-doubled Nd-YAG laser system which is used to write a pixel writing map and/or a pixel arrangement into an optical element 110.

**Table 1: Numerical values of selected laser beam parameters for a Nd-YAG laser system**

| Overview | | |
|---|---|---|
| Parameter | Numerical value | Unit |
| Pulse energy | 0.05 - 50 | µJ |
| Pulse length | 0.05 - 100 | ps |
| Repetition rate | 1 -10 000 | kHz |
| Pulse density (2D, lateral) | 10 - 10 000 000 | mm⁻² |
| NA | 0.1 - 0.9 | |
| Wavelength | 350 - 2000 | nm |

The pixel density refers to a 2D density in a plane perpendicular to the beam direction (lateral plane) or parallel to a local rear surface and/or a local front surface of the optical element.

As indicated in table 1, the parameter ranges of laser pulses used for the generation of pixels are large. Hence, the properties of pixels may also be quite different. Typically, a laser pulse does not generate a pixel in form of a sphere but creates a pixel having a form similar to an ellipsoid or a spheroid. The length of the spheroid is in a range of 1 µm to 50 µm and its width or thickness extends, for example, from 0.5 µm to 10 µm. Characteristic lengths to thickness ratios are in the range of 2 to 10. As indicated in table 1, pixel densities in the lateral plane are 10³ to 10⁷ pixels per square mm. One-dimensional pixel densities in beam or depth direction cover a range of 1 to 100 pixel(s) or 2D pixel layers per mm.

The steering mirror 290 directs the pulsed laser beam 225 into the focusing objective 240. The objective 240 focuses the pulsed laser beam 235 through the rear substrate surface into the substrate of the photolithographic mask 110. The NA (numerical aperture) of the applied objective depends on the predetermined spot size of the focal point and the position of the focal point within the substrate of the transmissive mask 110 relative to the rear substrate surface. As indicated in table 1, the NA of the objective 240 may be up to 0.9 which results in a focal point spot diameter of essentially 1 µm and a maximum intensity in focus of essentially 10²⁰ W/cm².

The apparatus 200 also includes a controller 280 and a computer 260 which manage the translations of the two-axis positioning stage of the sample stage 220 in the plane perpendicular to the laser beam (x- and y-direction). The controller 280 and the computer 260 also control the translation of the objective 240 perpendicular to the plane of the chuck 220 (z-direction) via the one-axis positioning stage 250 to which the objective 240 is fixed. It should be noted that in other implementations of the apparatus 200 the chuck 220 may be equipped with a three-axis positioning system in order to move the optical element 110 or the mask 110 to the target location and the objective 240 may be fixed, or the chuck 220 may be fixed and the objective 240 may be moveable in three dimensions. It is also conceivable to equip both the objective 240 and the chuck 220 with three-axis positioning systems. It should be noted that manual positioning stages can also be used for the movement of the optical element 110, as for example a transmissive or a reflective mask, to the target location of the pulsed laser beam 235 in x-, y- and z-directions and/or the objective 240 may have manual positioning stages for a movement in three dimensions.

Further, the apparatus 200 may also provide a viewing system including a detector 265, as for example a CCD (charge-coupled device) camera, which receives light from an illumination source arranged to the chuck 220 (not shown in Fig. 2) via the dichroic mirror 245. The viewing system facilitates navigation of the optical element 110 to a target position. Further, the viewing system may also be used to observe the formation of a modified area in the optical element 110 by writing a pixel arrangement with the laser beam 235 of the light source 230 into the optical element 110.

The computer 260 may be a microprocessor, a general-purpose processor, a special purpose processor, a CPU (central processing unit), a GPU (graphic processing unit), or the like. It may be arranged in the controller 280, or may be a separate unit such as a PC (personal computer), a workstation, a mainframe, etc. The computer 260 may further comprise I/O (input/output) units like a keyboard, a touchpad, a mouse, a video/graphic display, a printer, etc. Moreover, the computer 260 may comprise one or several connection ports through which it may send a request for experimental data to, for example, the control unit 170 of the confocal microscope 100 of Fig. 1. In addition, the computer 260 may also comprise a volatile and/or a non-volatile memory. The computer 260 may be realized in hardware, software, firmware, or any combination thereof. Moreover, the computer 260 may control the laser source 230.

A non-volatile storage of the computer 260 may store a three-dimensional (3D) surface contour of an optical element 110. The computer 260 may receive experimental raw data from the control unit 170 of the confocal microscope 100. Alternatively, it may receive processed data from the control unit 170. The computing unit of the computer 260 may comprise a 3D deformation model. The 3D deformation model may use a surface contour or a surface contour deformation and a pixel writing map as input data to determine or calculate a writing depth for the pixel writing map. It is also possible that the 3D deformation model determines one or more pixel arrangements which correct a defect of the optical element 110 without inducing any significant changes of the surface contour of the optical element 110. Further, the 3D deformation model may also use defect data of an optical element 110 and a surface contour deformation of the optical element 110 as input data to calculate one or more pixel arrangements which correct both, the determined surface contour deformation and the defect of the optical element 110.

The one or more pixel arrangement determined by the computer 260 based on a 3D deformation model may comprise two or more pixel layers to be written into various depths of the optical element 110. The pixel writing process by the apparatus 200 may be interrupted after the generation of the first or generally a i^{th} pixel layer and the confocal microscope 100 may be used in order to measure or determine the surface contour deformation induced by the introduction of the first (or the i^{th}) pixel layer. It is further possible to analyse a remaining defect rest. If the defect correction process is not executed as planned, the computing unit of the computer 260 may use the 3D deformation model to calculate a modified second (or the (i+1)^{th}), several of the pixel layers which remain to be written, or all pixel layers of the pixel arrangement which remain to be written so that the corrected surface contour agrees with a predetermined surface contour and/or a remaining defect rest is below a predetermined threshold at the end of the correction process.

It is also possible that the supplier of an optical element provides data with respect to a deviation of an existing surface contour from a predetermined surface contour.

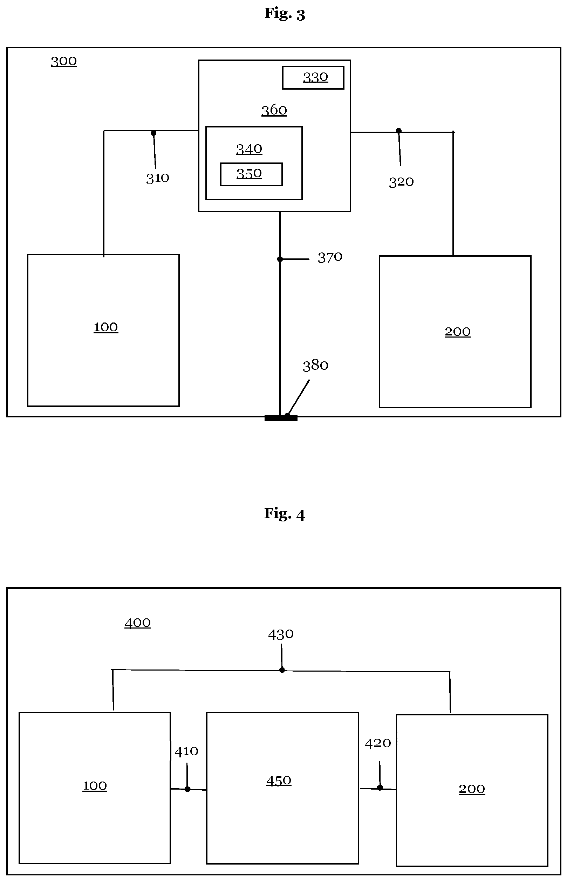

Fig. 3 schematically depicts an apparatus 300 which can be used for detecting and/or correcting defects and surface contour deformations of an optical element 110. The apparatus 300 combines the confocal microscope 100 of Fig. 1 and the pixel writing tool 200 of Fig. 2. Further, the apparatus 300 comprises a computer system 360 which is connected via the connections 310 and 320 to the confocal microscope 100 and the pixel writing tool 200, respectively. The computer system 360 of the apparatus 300 may have a control unit 330 which controls both, the apparatus 100 determining a surface contour of an optical element 110 and the pixel writing tool 200. The computer system 360 may have a memory 340 which stores a 3D deformation model 350. The computer system 360 may use the 3D deformation model 350 to calculate a writing depth for a pixel writing map. Further, the computer system 360 may use the 3D deformation model 350 to calculate one or more pixel arrangements which can be written into the optical element 110 in order to correct a determined surface contour deformation, a determined defect or both. Moreover, the apparatus 300 comprises an interface 380 which is connected to the computer system 360 via a connection 370. The computer system 360 may obtain surface contour data, surface contour deformation data, and/or defect data via the interface 380.

Fig. 4 schematically presents an apparatus 400 which contains the apparatus 100 of Fig. 1, the apparatus 200 of Fig. 2 and an apparatus 450. The apparatus 450 may be used for detecting registration changes and/or overlay changes. The apparatus 450 is connected to the confocal microscope of Fig. 1 and the pixel writing tool of Fig. 2 via the connections 410 and 420, respectively . The confocal microscope 100 and the pixel writing tool 200 may exchange data via the connection 430. Each of the apparatuses 100, 200, 450 of the apparatus 400 may have its own computer or computing system (not shown in Fig. 4) as described above in the context of Figures 1 and 2. In an alternative configuration, similar to Fig. 3, the apparatus 400 may have one single computing system which controls the confocal microscope 100, the registration and/or overlay metrology tool 450 and the pixel writing tool 200. The apparatus 400 as presented in Fig. 4 is more expensive than the apparatus 300 having a central computing system 360 but offers more flexibility with respect to the process management of a defect correction process.

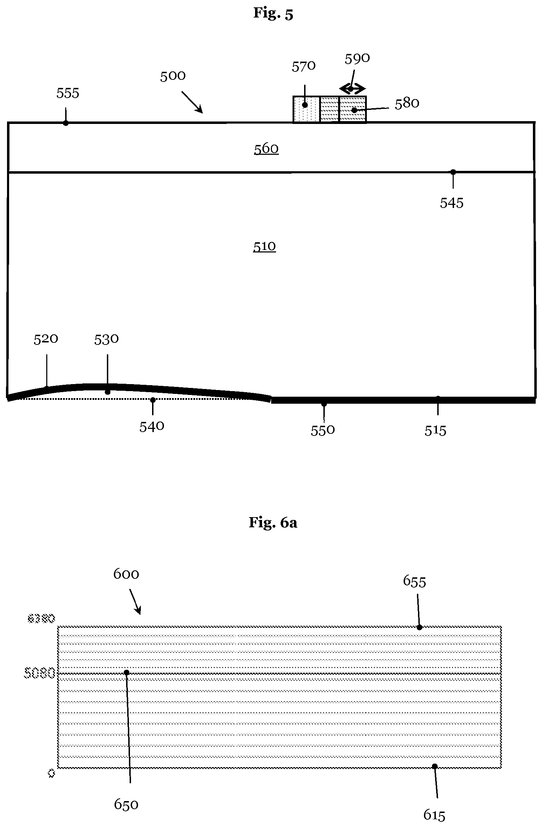

Fig. 5 shows a schematic cross-sectional view of an EUV mask 500 for an exposure wavelength of 13.5 nm. The EUV mask 500 comprises a substrate 510. The substrate 510 may comprise a fused silica substrate. Other transparent dielectrics, glass materials or semiconducting materials may also be applied as substrates 510, as for example ZERODUR^{®}, ULE^{®} or CLEARCERAM^{®}.

The mask substrate 510 comprises a rear surface 515 and a front surface 545. The rear surface 515 has a surface contour 520 which deviates from a predetermined flat surface contour 540. This means the rear substrate surface 515 has a surface contour deformation 530.

The substrate 510 of an EUV mask 500 typically has lateral dimensions of 152 mm x 152 mm and a thickness or height of essentially 6.35 mm. The rear surface or backside 515 of the substrate 510 normally has a thin metallic coating. For example, the coating may comprise at least one metal of the group of: nickel (Ni), chromium (Cr), aluminum (Al), gold (Au), silver (Ag), copper (Cu), tantalum (Ta), titanium (Ti), wolfram (W), indium (In), platinum (Pt), molybdenum (Mo), rhodium (Rh), and/or zinc (Zn) and/or mixtures of at least two of these metals. The thickness of the metal coating layer is typically in a range of 50 nm or smaller. The metallic coating is used for fixing the mask 500 to an EUV scanner by using an electrostatic chuck. Other materials as for example boron (B) or chromium nitride (CrN) as also be used for generating thin backside coating for an EUV mask 500.

In order to have access to the mask substrate 510 for the pixel writing tool 200, the metallic coating can be replaced by an optically transparent and electrically conductive coating 550. Such a transparent conductive coating 550 may for example comprise indium tin oxide (ITO). Alternative materials for optically transparent and electrically conductive coatings are, for example, fluorine tin oxide (FTO) and/or aluminium zinc oxide (AZO) and/or antimony tin oxide (ATO). These materials can easily be applied to the rear substrate surface 515 of a fused silica substrate 510 and have am electrical conductivity which is high enough for electrostatically chucking a photomask to an EUV scanner. The optically transparent and electrically conductive coating 550 enables to irradiate an EUV mask 500 with light pulses of the pixel writing tool 200 through the rear substrate surface 515.

A multilayer (ML) mirror system 560 is deposited on a front surface 555 of the substrate 510. The multilayer mirror system 560 typically comprises 20 to 80 pairs of alternating molybdenum (Mo) and silicon (Si) layers. The normal thickness of each Mo layer is 4.15 nm and that of the Si layer amounts to 2.80 nm. To protect the ML structure 560, a capping layer of silicon with a native oxide of 7 nm depth is typically arranged on top of the ML 560 (not shown in Fig. 5). The ML 560 on the substrate 510 acts a mirror or a reflector for EUV electromagnetic radiation. Presently, a ML 560 can reflect approximately 70% of the incident EUV photons.

When fixing the EUV mask 500 with an electrostatic chuck, typically its rear surface 515 is flattened during the operation of the EUV mask 500. This in turn will lead to aberrations of the multilayer structure 560 arranged on the substrate 510 compared with an essentially flat front surface 555. The aberrations caused by the rear surface contour deformation 530 can neither be removed by varying the position of the wafer nor by changing the reproduction scale. Thus, the rear surface contour deformation 530 has to be corrected.

An absorbing layer is generated on a buffer layer (not presented in Fig. 5). The absorbing layer 240 may comprise a material having a large absorption constant for photons in the EUV wavelength range. Examples of these materials are chromium (Cr) and/or tantalum nitride (TaN). A thickness of about 50 nm is typically enough to absorb essentially all EUV photons incident on the absorbing layer.

Fig. 5 schematically shows a pattern element 570 at a position according to the EUV mask design. The pattern element 580 which is actually fabricated shows a shift 590 compared to the design data. Thus, the pattern element 580 has a registration defect 590 which has to be corrected so that the EUV mask 500 projects a predetermined pattern on a wafer in an exposure process. Therefore, the EUV mask 500 has both, a surface contour deformation 530 and a registration defect 590. In Fig. 5, the EUV mask 500 has the surface contour deformation 530 on the rear surface 515 and the registration defect 590 on the front surface 555. It is also possible that the EUV mask 500, or generally an optical element, has both a surface contour deformation and a defect on the same surface, e.g. the front surface 555.

At first, the quality of the 3D deformation model is tested and the tool specific parameters in form of a 3D expansion signature (ES) are determined. For this purpose, a test mask for the deep ultraviolet (DUV) wavelength range is selected. The test mask should have a respective density of structure elements either in form of pattern elements and/or in form of overlay marks.

In a first step, the positions of the structure elements of the test mask are measured by using a registration metrology tool. In the second step, a pixel writing map is generated or written in the test mask. Fig. 6a shows a cross-section of the test mask 600. The pixel writing map 610 (not depicted in Fig. 6a) is written into a depth 650 of 5.08 mm or 5080 µm from the rear surface 615 of the test mask 600.

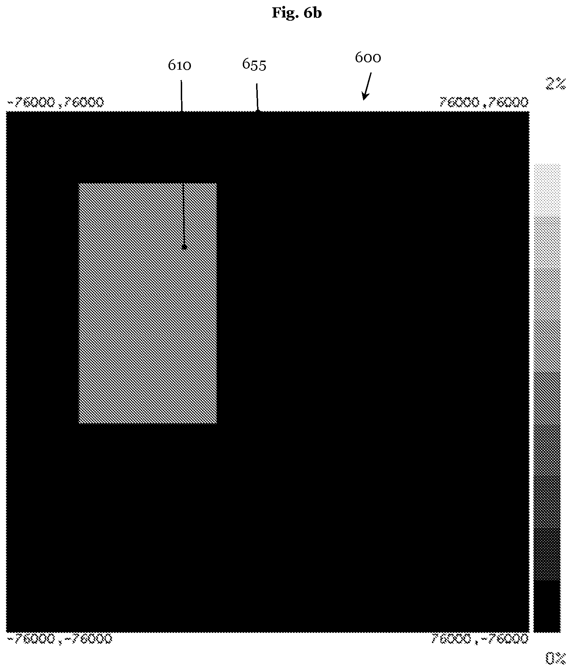

Fig. 6b illustrates the pixel writing map 610 and indicates the density variation induced by the pixel writing map 610 at the rear surface 615 of the test mask 600. The pixel writing map 610 has a rectangular shape and a homogeneous pixel density. The pixel writing map 610 induces an optical density variation 610 or an optical transmission change of about 1% at a DUV wavelength of 193 nm, as it is indicated by the scale on the right side of Fig. 6b. As one may notice, the resulting registration change looks like a compaction of the rear surface 615 of the test mask 600. This is a result of a mask bending when writing pixels in a depth which is different from the depth center. The writing of expanding pixels in the upper part of the test mask 600 (the part which is close to the front surface 655) induces a surface contour deformation in form of a mask bending which leads to a compression at the rear surface 615 of the test mask 600.

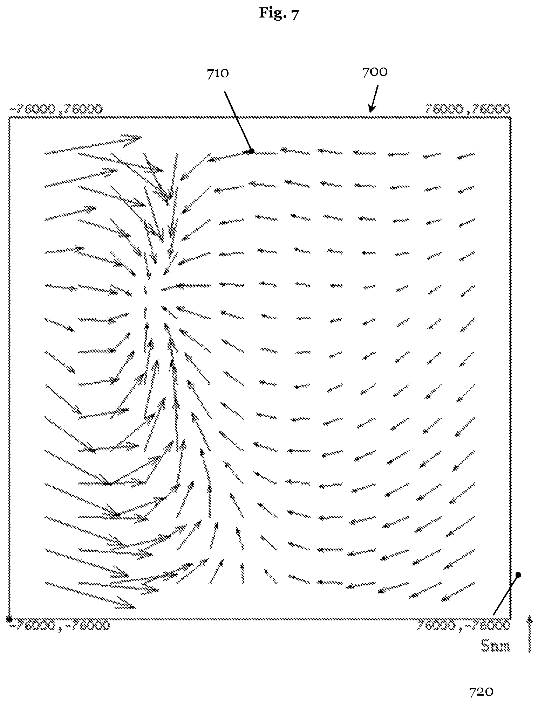

In the next step, a shift of the structure elements is measured by using the registration metrology tool which have been used to determine the positions of the original structure elements. The diagram 700 of Fig. 7 shows the measured displacements of the structure elements of the test mask 600 induced by the pixel writing map 610 written into the test mask 600 in a depth of 5080 µm. The length of the arrows 710 indicates the amount of the displacement of the structure elements on the front surface 655 across the test mask 600 and the arrowhead of the arrow 710 specifies the displacement direction of the structure elements. The arrow 720 at lower right corner of Fig. 7 represents a displacement amount of 5 nm.

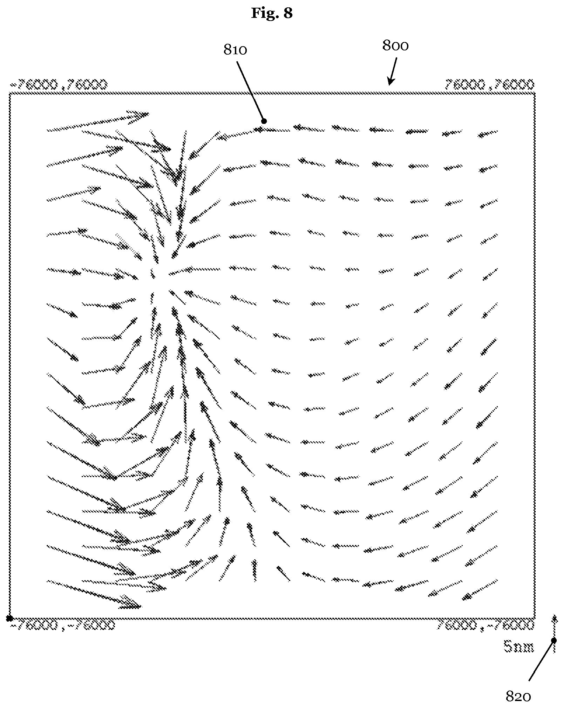

Diagram 800 of Fig. 8 represents the displacements of the structure elements of the test mask 600 caused by the pixel writing map 610 in the depth 650 of 5080 µm which are obtained as a best fit to the measured displacements indicated in Fig. 7. The arrows 810 and 820 have the meaning indicated in the previous paragraph. A 3D deformation model was used to simulate the registration change induced by the pixel writing map. The tool specific parameters or the ES (expansion signature) are determined as fit parameters in the simulation process in order to obtain a best match between measured and simulated displacements.

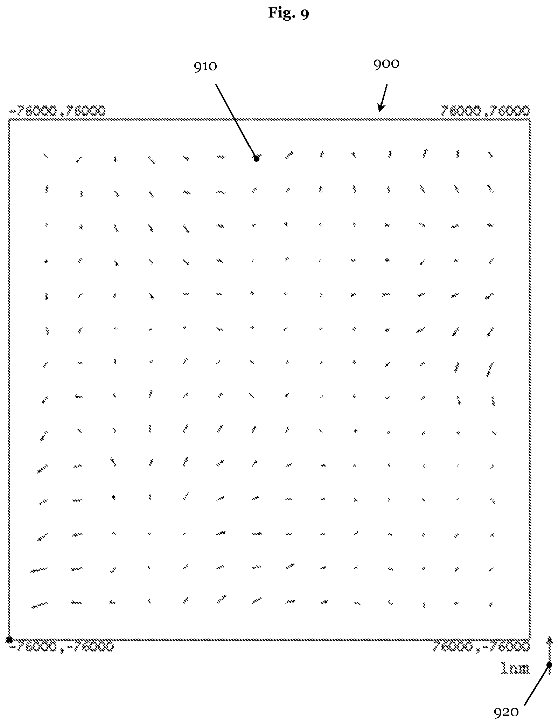

Diagram 900 of Fig. 9 presents the differences between the measured registration changes of Fig. 7 and the calculated or simulated registration changes of Fig. 8. The small arrows 910 represent the remaining local mismatch. The arrow 920 at the right lower corner depicts a displacement amount of 1 nm. The length of the arrow 920 is only 20% of the length of the arrows 720 and 820 of Fig. 7 and 8, respectively. This means that the fit mismatch is enlarged by a factor or 5. The remaining differences are a characteristic of the fit quality. Further, and more important, the differences or mismatches of Fig. 9 comprise a number of contributions: the error of modelling the registration changes induced by the pixel writing map, the errors of writing the pixel writing map into the test mask 600, i.e. the ES parameters, the errors of measuring the induced displacements of the structure element on the test mask 699, the errors resulting from the noise of the registration metrology tool.

The 3σ numerical value of the remaining or residual mismatch of the registration fit is 0.44 nm. This value is significantly lower than the noise of a registration metrology tool which is around 0.7 nm. This result has been reached by multiple sampling the induced registration displacements of Fig. 7. The result presented in Fig. 9 impressively demonstrates the performance of the 3D deformation model which allows to reveal a defect with a higher precision than it can be detected by an experiment.

In the following, ES parameters derived from registration measurements are also referred to ESR (expansion signature registration).

The 3D deformation model connects induced tangential surface changes of an optical element, as for example registration displacements of the test mask 600, with normal surface changes of the optical element, as for example a surface contour deformation of the test mask 600. This means that in principle a detected surface contour deformation may be used to deduce the tool specific ES parameters. For determining the ES parameters from a mask bending or generally from a surface contour deformation of an optical element, the same approach as for the determination of ESR is used. The ES parameters deduced from a determined surface contour deformation are in the following also called ESF (F for flatness).

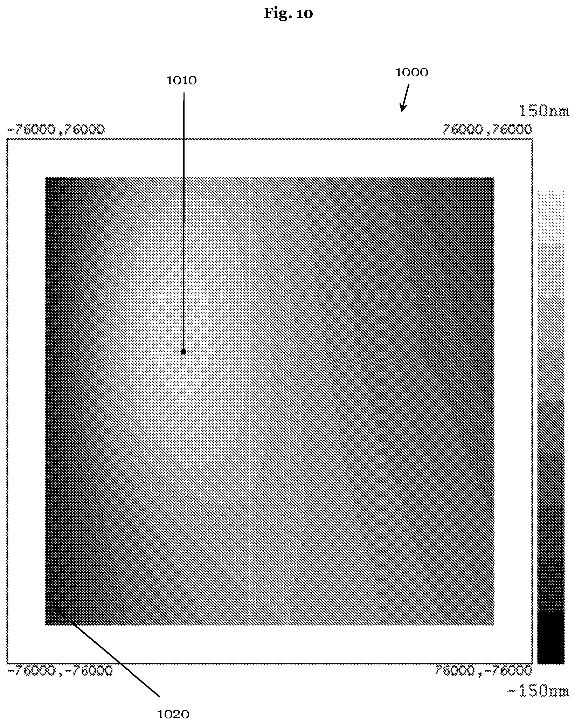

In a first step, parallel to the initial positions of the structure elements of the test mask 600, the initial rear surface contour of the test mask 600 is measured, for example by using the confocal microscope 100 of Fig. 1. The pixel writing tool of Fig. 2 generates the pixel writing map 610 in a depth 650 of 5080 µm as indicated in Fig. 6b. Diagram 1000 of Fig. 10 presents the surface contour deformation 1000 as a difference between the initial surface contour and the surface contour resulting from the generation of the pixel writing map 610 in the test mask 600. As indicated by the scale on the right side of Fig. 10, the surface contour varies within a range of 300 nm. In Fig. 10, as indicated by the points 1010 and 1020, the height of the rear surface deformation 1000 varies in a range of about 200 nm across the test mask 600.

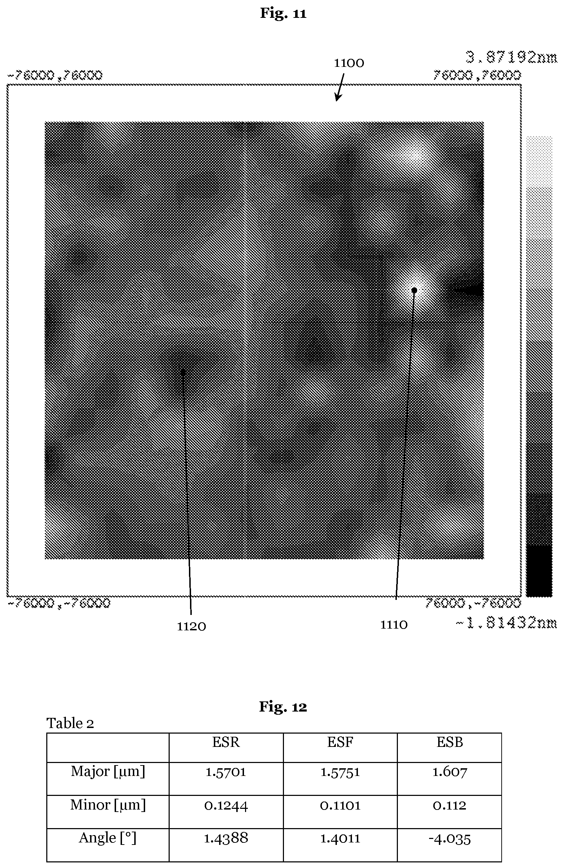

Similar to Fig. 9, diagram 1100 of Fig. 11 presents the residual or remaining mismatch between the measured surface contour deformation of Fig. 10 and a simulated surface contour deformation (not shown). In the best fit between measured and simulated surface contour deformation, the tool specific ES parameters are determined. As indicated by the scale on the right side of diagram 1100, the scale extends across a range of about 6 nm (from about -2 nm to about +4 nm). Fig. 11 shows that a residual mismatch between the measured and simulated or calculated surface contour deformation is approximately 5 nm. This remaining mismatch is indicated by the points 1110 and 1120 in Fig. 11. The 3σ numerical value of the remaining fit surface contour mismatch is 2.4 nm. This is lower than the noise of a metrology tool used to determine or measure the surface contour of an optical element, as for example, the confocal microscope 100.

It is also possible to determine the tool specific ES parameters from birefringence measurements of the optical element 110, 600 having the pixel writing map 610. Table 2 of Fig. 12 presents tool specific ES (expansion signature) parameters deduced from measured registration data (ESR), surface contour or flatness data (ESF) and birefringence data (ESB). In table 2 major and minor denote the components of a diagonalized infinitesimal strain tensor and characterise the shape deformation induced by 1 mm² of the pixels of the pixel writing map 610 generated in the test mask 600. The angle in table 2 denotes the orientation of a coordinate system which has diagonalized the strain tensor. The numerical values of the ES parameters determined from registration and flatness or surface contour deformations are consistent with each other. As a consequence of a week birefringence signal of the test mask 600, the ES parameters deduced from birefringence measurements are slightly different.

Table 2 reveals that both registration data and surface contour deformation data can be the basis for determining tool specific ES parameters. Like the other approaches for determining ES and/or MS parameters, there are also some limitations. As already discussed above, when writing pixels close to the depth center, ES parameters can only be determined having a large error interval. Further, not all parameters of a 3D ES (ES3) may be deduced from a surface contour deformation, because the effects of a surface contour deformation are similar to the effects of an induced registration change.

A full set of ES parameters describes all possible deformations of a cubic or more generally of a cuboid of the optical element induced by writing of the pixel writing map 610 into the test mask 600. A cubic or a cuboid has eight corners each having three degrees of freedom (x-, y- and z-direction). In total this results in 24 degrees of freedom. When removing three directions of shift and three directions of rotation of the overall optical element 18 degrees of freedom are left. But not all these parameters essentially contribute to a deformation of the investigated optical element. For example, if the optical element is a photomask, as illustrated in Figures 5 and 6, an expansion in the z-direction causes a very small impact on the overall deformation of the investigated cuboid due to its small value compared to the x- and y-directions (152 mm x 152 mm x 6.35 mm) and the layer structure of this type of optical element. Not all deformation parameters may be determined by only performing registration measurements, birefringence measurements and surface flatness measurements. However, this is not critical as long as the contribution of the undefined parameters can be neglected. The assumption is verified by modelling. In the following, the undetermined parameters are set to zero.

In a second item, the writing depth of a pixel writing map or a pixel arrangement is now deduced from a determined or measured surface contour deformation. At first, the writing depth is derived by matching a measured surface contour with a simulated surface contour deformation wherein the ES parameters are determined from induced registration changes by writing the pixel writing map 610 into the test mask 600 as discussed above.

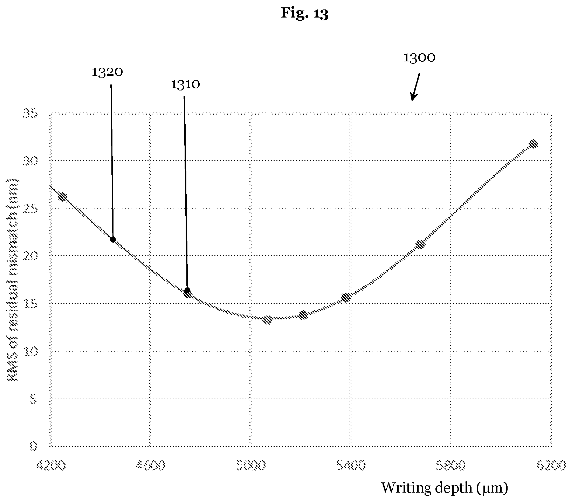

The dots 1310 of diagram 1300 of Fig. 13 depict a residual mismatch between the determined surface contour deformation of Fig. 10 and simulated surface contour deformation induced by the pixel writing map 610 when written in various depths of the test mask 600. As indicated in Fig. 6a, the pixel writing map 610 has been generated in a depth 650 of 5080 µm. Fig. 13 presents the simulated surface contour deformations of seven different writing depths 1310 within a depth range of 4200 µm to 6200 µm. The ordinate of diagram 1300 indicates the route mean square (RMS) residual or remaining mismatch between the determined or measured surface contour deformation. The curve 1320 shows the behaviour of the residual mismatch trend when fitting the obtained data with a fourth-degree polynomial. The minimum of the fitted curve 1320 is at about 5075 µm which is very well consistent with the writing depth of 5080 µm of Fig. 6a.

As already mentioned above, the ES parameters have been determined based on measured registration changes induced by a pixel writing map 610. Further, as summarized in table 1, the ES parameters can also be deduced from one or more surface contour deformations. In the next step, it is the objective to determine both, the ES parameters and the writing depth 650 from induced surface contour deformations. The criteria for simultaneously establishing the ES parameters and the writing depth is again the difference between the determined or measured surface contour deformation and the simulated surface contour deformations for various writing depths 650 of the pixel writing map 600.

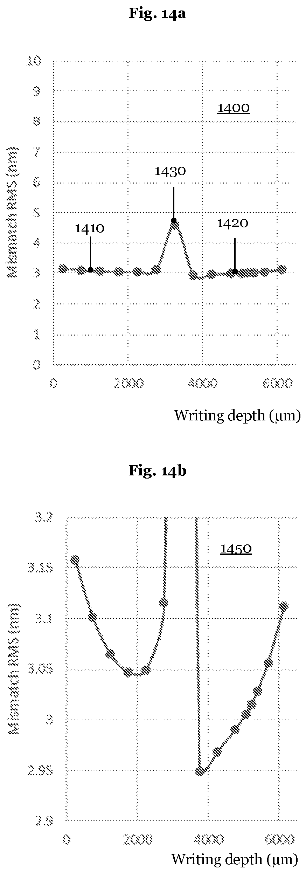

Diagrams 1400 and 1450 of Fig. 14a and 14b show the remaining RMS mismatch between the determined or measured surface contour deformation and the simulated surface contour deformations as a function of the writing depth for the pixel writing map 610 of Fig. 6b. Fig. 14b presents the data of Fig. 14a with an enlarged ordinate.

At first glance, the results of diagrams 1400 and 1450 are disappointing. The residual mismatch does not show a defined minimum at all. There are two large plateaus 1410 and 1420 and the curves of Fig. 14a and 14b show a large remaining mismatch 1430 at the center or the center depth of the test mask 600. As already discussed above, the large mismatch at the center depth is a principle problem. Writing a pixel writing map 610 at the center depth of the test mask 600, or generally of an optical element, minimizes the effect on the surface contour variation of the optical element 110, 600. Thus, an induced surface contour deformation can only be determined with a significant uncertainty. This is correct for both, surface contour deformations determined from measurements and surface contour deformations determined from simulations. The following diagrams also show the principal mismatch at the center writing depth.

For measuring and simulating the surface contour deformations which are the basis of the curves in diagrams 1400 and 1450 of Fig. 14a and 14b, the uniform pixel writing map 610 of Fig. 6b has been used. For a uniform pixel writing map 610, the induced surface contour deformation depends on the size of the pixels containing in the writing map 610, or the writing strength, and on the distance of the writing depth 650 from the center depth. The surface contour deformation dependence resulting from both quantities, the pixel size and the difference between the writing depth and the mask center are very similar when generating a uniform writing map in the test mask 600. Mathematically it is not possible to distinguish between the contribution of the writing depth and the pixel size to the induced surface contour deformation. The contribution of the two quantities can only be observed, and thus separated, at the edges of the pixel writing area. Moreover, the two contributions should be more easily distinguishable when writing the pixel writing map 610 closer the front surface 655 of the test mask 600.

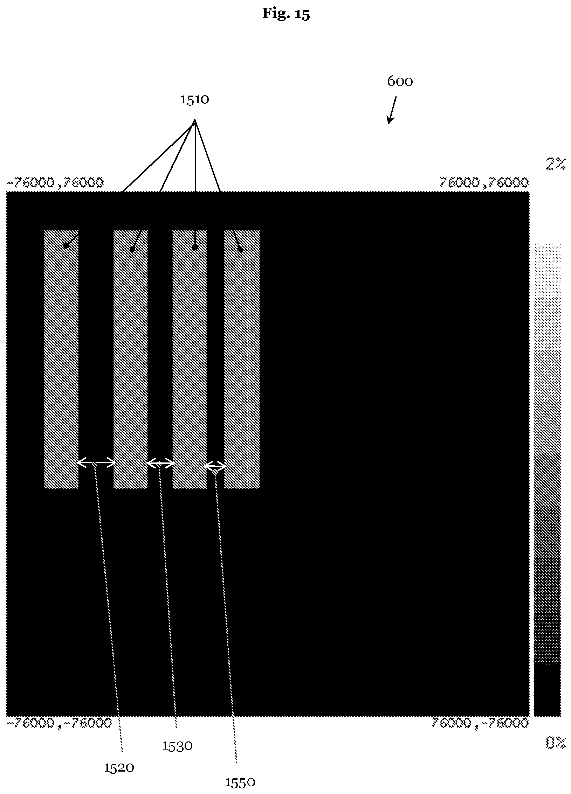

Fig. 15 depicts a second example of the test mask 600 into which a pixel writing map 1510 is written into a depth of again 5080 µm as illustrated in Fig. 6a. The pixel writing map 1510 comprises four vertical stripes having an identical width and length for the pixel writing map 1510. But the distances 1520, 1530 and 1540 varies between the different stripes. Hence, the pixel writing map 1510 has a sub-structure with more edges than pixel writing map 610. The sub-structure or the increased ratio of circumference and area of the pixel writing map 1510 allows to more clearly distinguish between the pixel size, the ES size or magnitude and the contribution of the writing depth 650 with reference to the center depth.

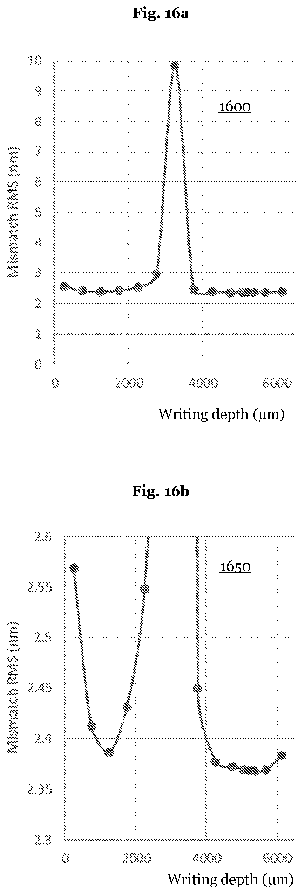

Similar to Fig. 14a and 14b, diagrams 1600 and 1650 of Fig. 16a and 16b present the remaining RMS mismatch between the determined or measured surface contour deformation and the simulated surface contour deformations for the pixel writing map 1510 as a function of the writing depth 650.

The residual mismatch of Fig. 16a and 16b is significantly smaller than in Fig. 14a and 14b. This is a consequence of the more pronounced structure of the pixel writing map 1510 compared to the pixel writing map 610. Furthermore, Fig. 16b reveals a kind of minimum around a writing depth of 5200 µm. However, the result is not well defined due to significant metrology noise of the tool used for determining the induced surface contour deformation.

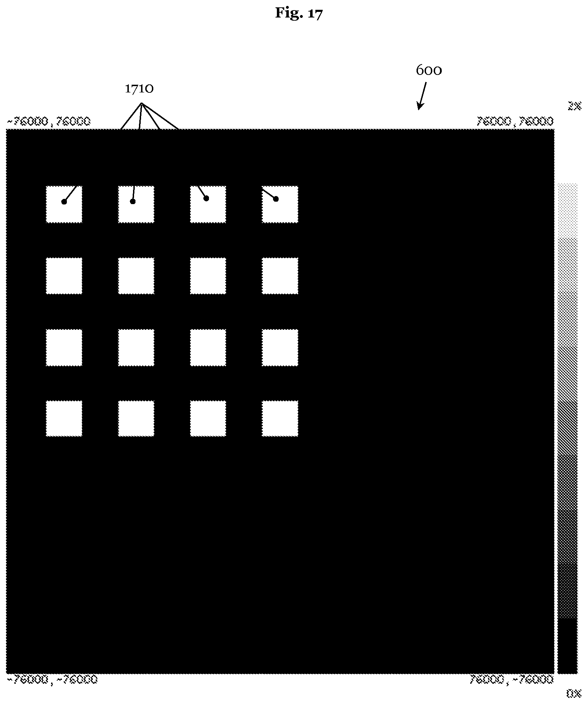

Therefore, a third pixel writing map has been designed which has a sub-structure adapted to the writing depth 650 of 5080 µm. The third pixel writing map 1710 still further increases the ratio of circumference and area ratio compared to the second pixel writing map 1510 of Fig. 15. Fig. 17 presents a third example of the test mask 600 into which the pixel writing map 1710 has been written. The pixel writing map 1710 has the shape of a square which contains 16 sub-squares arranged with equidistant spacings in both the x-direction and the y-direction.

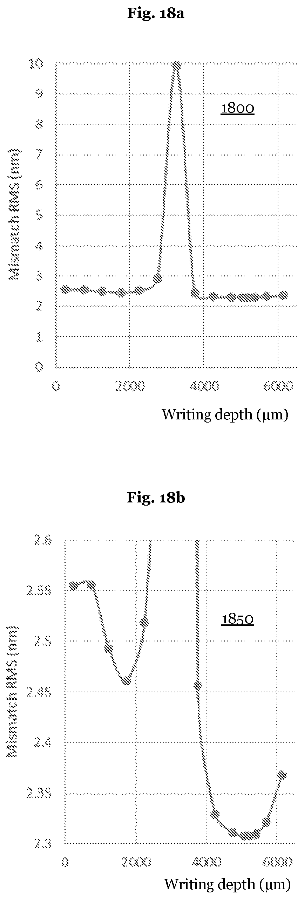

Diagrams 1800 and 1850 of Fig. 18a and 18b show the remaining RMS mismatch between the determined or measured surface contour deformation and the simulated surface contour deformation as a function or the writing depth. The residual mismatch has a well-defined minimum at a writing depth 650 of 5080 µm which corresponds to the depth into which the pixel writing map 1710 has been written in the test mask 600.

The spatial frequency content of a pixel writing map 610, 1510, 1710 that is transmitted to the front surface 655 of the test mask depends the depth 650 the pixel writing map 610, 1510, 1710 is generated in the test mask 600. In order to distinguish between the contribution of the ES parameters, i.e. the pixel size, and the contribution of the writing depth to the induced surface contour deformation, a pixel writing map must contain high spatial frequencies. However, the high spatial frequencies do not propagate far in the test mask 600, or generally in an optical element. This means that the spatial frequency content of the pixel writing map 1710 or its ratio of circumference and area should be adapted to the depth 650 into which the pixel writing map 610, 1510, 1710 is to be introduced. This secures an optimum accuracy at the determination of both the ES parameters and the writing depth from measured and simulated surface contour deformations.

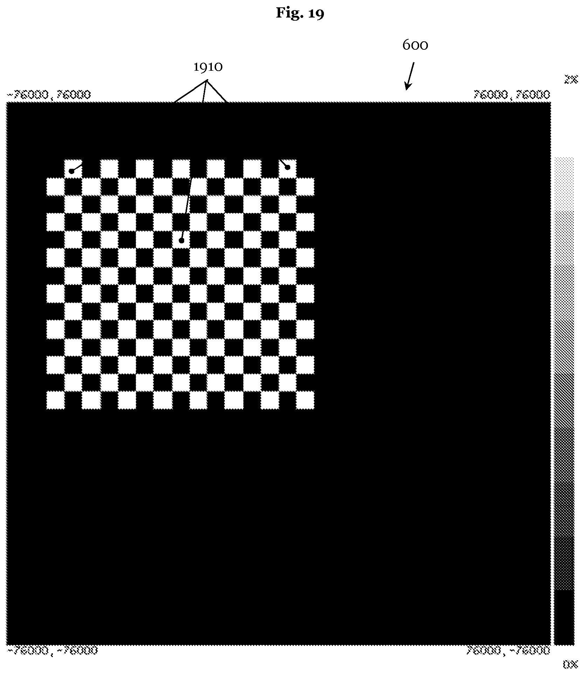

Fig. 19 presents a fourth example of a pixel writing map 1910 which is written in a further example of the test mask 600 at a depth of 1250 µm from the rear surface 615. The pixel writing map 1910 has a chessboard structure like the pixel writing map of Fig. 17. However, the fine structure, the spatial frequency content, or the ratio of circumference to ratio is adapted to the writing depth of the pixel writing map 1910.

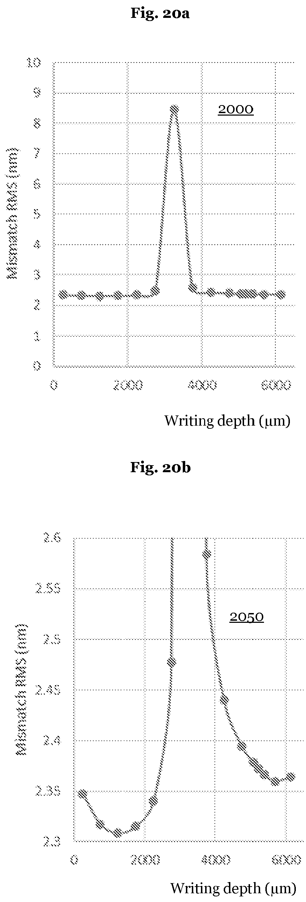

Diagrams 2000 and 2050 of Fig. 20a and 20b depict the residual RMS mismatch between the measured surface contour deformation and the simulated surface contour deformations calculated for various writing depths. The residual mismatch has a well-defined minimum at a writing depth of 1250 µm which agrees very well with the depth into which the pixel writing map 1910 has been generated. By comparing the determined surface contour deformation with the simulated surface contour deformations for the pixel writing map 1910, the ES parameters and the writing depth can simultaneously be reconstructed.

In the following, it is discussed how an induced surface contour deformation can be used for monitoring the correction of registration defects, as for example registration defect 590 of the EUV mask 500. In the example described below, it is assumed that the one or more registration defects are on the rear surface 615 of the test mask 600 and the surface contour deformation is also detected at rear surface 615. This is not a restriction of the described method. Rather, front surface registration defects may also be corrected, and the surface contour deformation induced at the rear surface of the mask or optical element may be used to monitor the registration defect correction or vice versa.

For correcting registration defects, a pixel arrangement is determined by using the 3D deformation model. The pixel arrangement contains pixel which predominantly induce a tangential surface modification at the rear surface 615 of the test mask 600 for correcting one or more registration defects. This means that the pixels of the determined writing map have essentially a 2D expanding expansion signature (ES) perpendicular to the beam direction of the pixel writing tool 200. It is assumed that the determination of the ES parameters has a mistake of 10%. This leads to an error of 10% when writing the determined pixel arrangement into a mask 110, 500, 600, or generally into an optical element. In most cases, an error of 10% of the ES parameters is not critical for correcting one or more registration defects. However, this error may result in a significant uncertainty of the induced surface contour deformation.

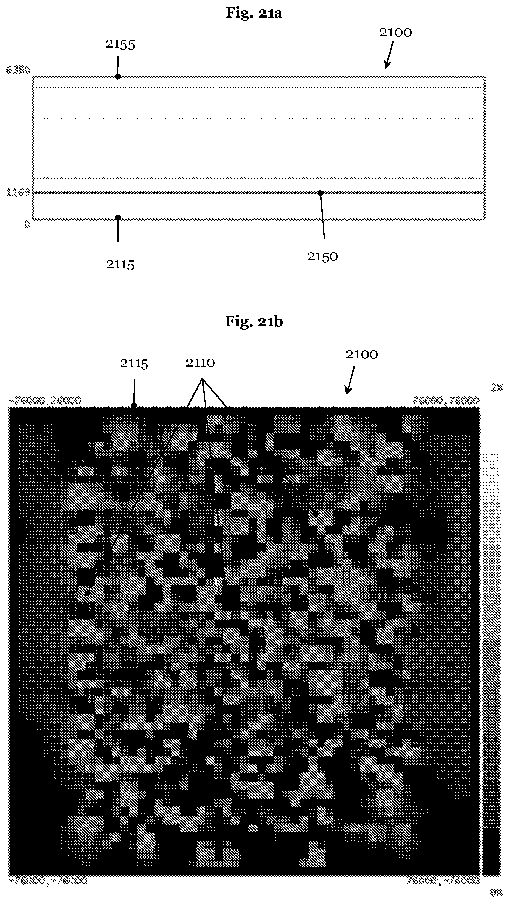

Fig. 21a presents a cross section of a test mask 2100 for the deep ultraviolet (DUV) wavelength range having a front surface 2155 and a rear surface 2115. As indicated in Fig. 21a the determined pixel arrangement 2110 is written into the test mask 2100 in a depth of 1169 µm. Fig. 21b presents the rear surface 2115 through which the pixel arrangement 2110 is introduced into the test mask 2100 in a depth 2150 of 1169 µm. The pixel arrangement 2110 has a complex structure. It induces an optical density variation of about 1.5%, as is indicated by the scale on the right side of Fig. 21b.

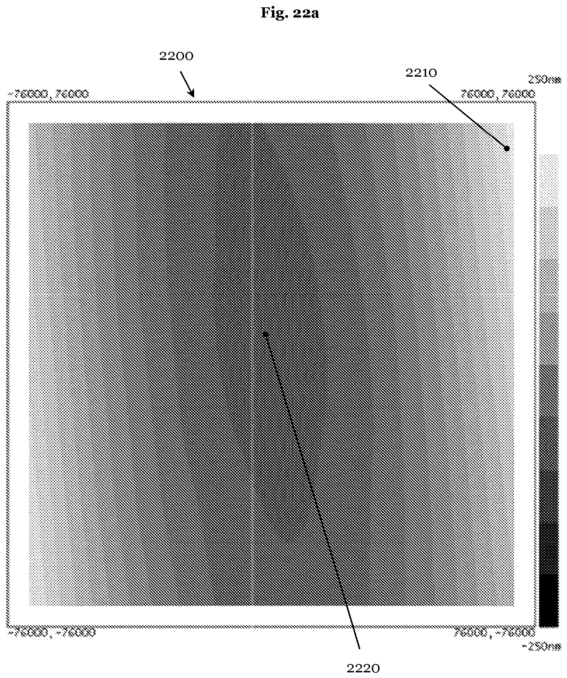

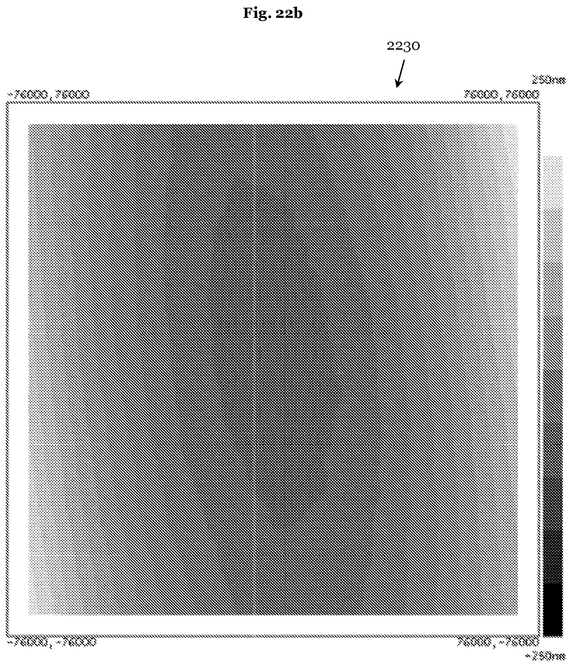

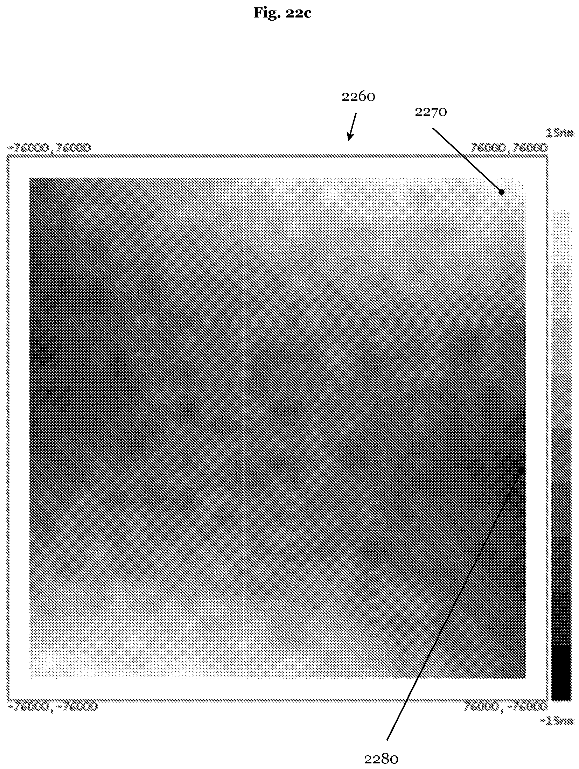

Fig. 22a show the simulated surface contour deformation 2200 induced in the test mask 2100 by the generation of the pixel arrangement 2110 in a depth 2150 of 1169 µm. The height of the rear surface 2115 of the test mask 2100 fluctuates about 300 nm between the positions 2210 and 2220. Fig. 22 b presents the measured surface contour deformation 2230 of the test mask 2100 induced by the introduction of the pixel arrangement 2110 at a depth of 1169 µm. Fig. 22a and 22b have an identical scale.

Fig. 22c depicts the difference between the surface contour deformations of Fig. 22a and 22b on an enlarged scale. The maximum difference between the measured and simulated height or measured and simulated surface contour deformation between the positions 2270 and 2280 is below 30 nm. Hence, it is possible to monitor a registration defect correction process by analysing the surface contour deformation induced by the pixel arrangement 2110 introduced into a photomask 2100, or generally into an optical element. Further, determining or analysing the induced surface contour deformation during a registration and/or an overlay defect correction process allows to qualify the accuracy of the defect correction process. Moreover, by monitoring the induced surface contour deformations during a defect correction process corrective measures can be taken if the determined surface contour deformation reveals that the defect correction process is out of control.

For example, if pixel arrangement 2110 does not completely remove the registration defect 590. A second pixel arrangement can be designed based on the detected defect rest which forces the residual defect rest below a prescribed threshold.

Often a pixel arrangement 2110 designed for correcting one or more registration defects and/or overlay defects comprises several layers or pixel layers. The defect correction process may be interrupted when the determined surface contour deformation signalizes that the correction process is no longer on track. The pixel layers of the pixel arrangement which remain to be written into the mask may be newly calculated so that they correct the identified deviation of the defect correction process. The determination of a relation which connects an induced surface contour deformation with the writing depth of a pixel arrangement, or a pixel layer - as discussed above - may be used for calculating new pixel layer(s) for the pixel arrangement.

It is also possible not to modify the pixel layers of a designed or calculated pixel arrangement but to calculate one or more additional layers which compensate the deviation of the performed defect correction process.

It might occur that the mistake of the pixel writing process does not or at least not predominantly result from a mistake at the determination of the ES parameters but is caused by one or more other factors. If this is the case, the difference between the measured and simulated surface contour deformation has a high residual mismatch. Such a result requires a more thorough analysis of the measured surface contour deformation. For example, induced registration and/or overlay measurements can be performed to obtain more details of the problem. Further, the ES parameters may newly be determined based on a measured registration change and/or a measured overlay change. Then one of the options discussed above can be applied to correct any defect rest.

Finally, a simultaneous correction of a defect and a surface contour deformation is described in the following. As already discussed above, the tangential surface change and the normal surface change of an optical element induced by a pixel or a pixel arrangement are coupled. Therefore, the correction of registration defects and/or overlay defects potentially impairs a surface contour of an optical element. If the optical element is a photomask their flatness may be degraded when one or both above defect types are corrected. The influence of the defect correction process on the surface contour of an optical element gets more important if the correction process requires a high spatial resolution which in turn needs to design pixel arrangements which have a significant content of high spatial frequencies. Typically, this requirement forces to generate the pixel arrangement close to the patterned mask surface.

A lithographic process typically uses a configuration having a high numerical aperture (NA) to maximize the optical resolution. But lithographic exposure systems having a high NA are very sensitive the flatness of the patterned surface of a photomask. The allowed overall flatness budget is very tight and thus leads to serious constraints for the contribution resulting from registration and/or overlay correction processes.

However, the knowledge of the actual mask flatness, or generally of the surface contour deformation of an optical element, enables formulating the registration and/or overlay correction process in a different way. Instead of limiting the induced mask bending or surface contour deformation as in the conventional approach, it is possible to target a registration and/or an overlay correction process so that it simultaneously also corrects or at least significantly improves an existing surface contour deformation or a mask surface flatness.

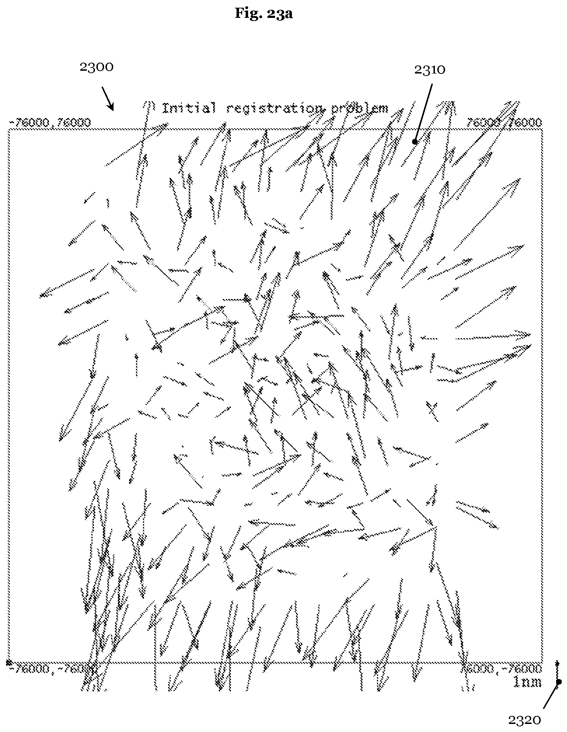

To evaluate the potential of a correction process which corrects both, a registration and/or an overlay defect and a surface contour deformation, a test mask is designed which has both defect types. Fig. 23a shows a hypothetic test mask 2300 having a registration problem. As already discussed in the context of Fig. 7, the length of the arrows 2310 indicates the local displacement amount of a pattern element and the arrowhead specifies the direction of the local displacement. The arrow 2320 at the lower right edge of Fig. 23a represents a displacement of 1 nm. The 3σ numerical value of the defined registration problem is 3.88 nm.

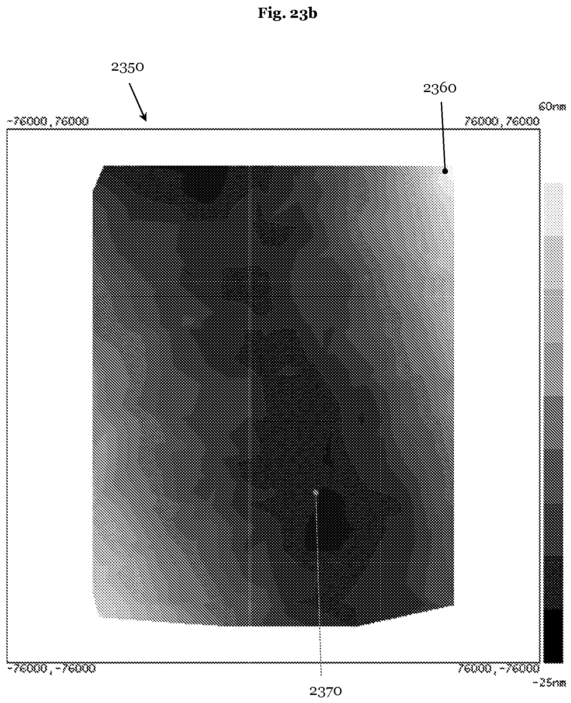

Diagram 2350 of Fig. 23b shows that the mask 2300 also has a flatness problem or a surface contour deformation. The scale on the right side of Fig. 23b span a height difference of 85 nm. As illustrated by the extremes 2360 and 2370, the height of the mask 2300 varies within a range of 78 nm. This is significantly larger than a predetermined error budget of 30 nm for photomasks having an actinic wavelength in the EUV wavelength range.

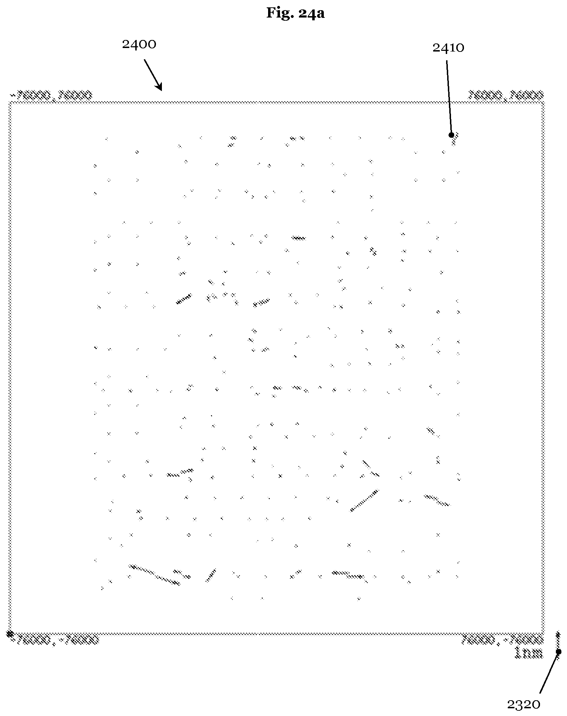

The conventional approach of solving these problems is illustrated in Fig. 24a to 24c. Diagram 2400 of Fig. 24a shows the remaining registration after a registration correction process has been performed by simulation. The arrows 2410 illustrate the remaining registration. Like in Fig. 23b, the arrow 2320 represents a shift of 1 nm. The 3σ numerical value of the displacement can be reduced in simulation starting form 3.88 nm down to 0.42 nm which is an improvement of 89.2%.

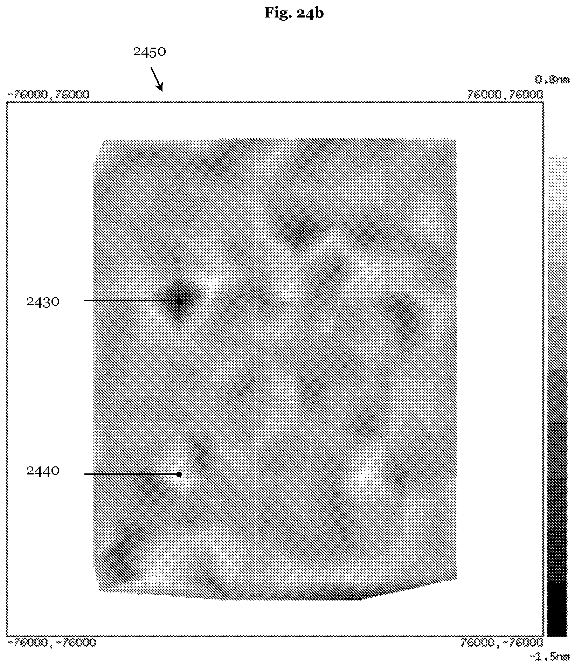

When performing the registration correction simulation, the surface contour deformation has not been considered. Diagram 2450 of Fig. 24b shows the effect of the registration correction on the surface contour deformation or the existing mask bending of the mask of Fig. 23b. The scale on the right side of Fig. 24b extends across a height range of 2.3 nm. The maximum height change, as illustrated by the positions 2430 and 2440, resulting from the registration correction process demonstrated in Fig. 24a is approximately 2 nm.

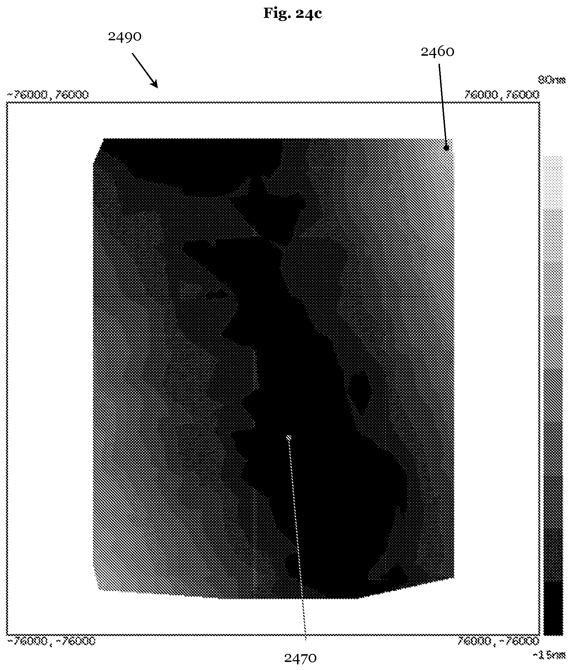

Diagram 2490 of Fig. 24c represents the mask flatness or the surface contour deformation resulting from the addition of the initial surface contour deformation as indicated in Fig. 23b and the contribution added by the registration correction process. There is no noticeable change of the surface contour deformation of Fig. 24c compared to Fig. 23b. After solving the registration problem, the mask bending problem is addressed in a second correction process.

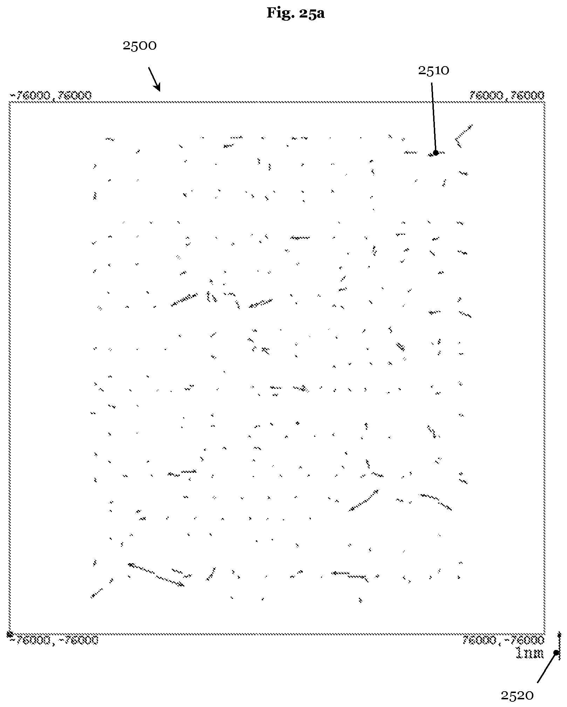

The new approach presented in this application simultaneously corrects the registration problem of the defined mask 2300 presented in Fig. 23a and the surface contour deformation or the mask bending defined in Fig. 23b. Diagram 2500 of Fig. 25a depicts the residual registration after simulating the registration displacements and simultaneously taking into account the mask bending, or the surface contour deformation. The arrows 2510 represent the residual local displacements after performing the registration correction process. Similar to Fig. 24a, the arrow 2520 indicates a displacement of a pattern element by 1 nm. The 3σ numerical value of the residual displacement amounts 0.62 nm which is an improvement of 84% referred to the initial registration problem depicted in Fig. 23a.

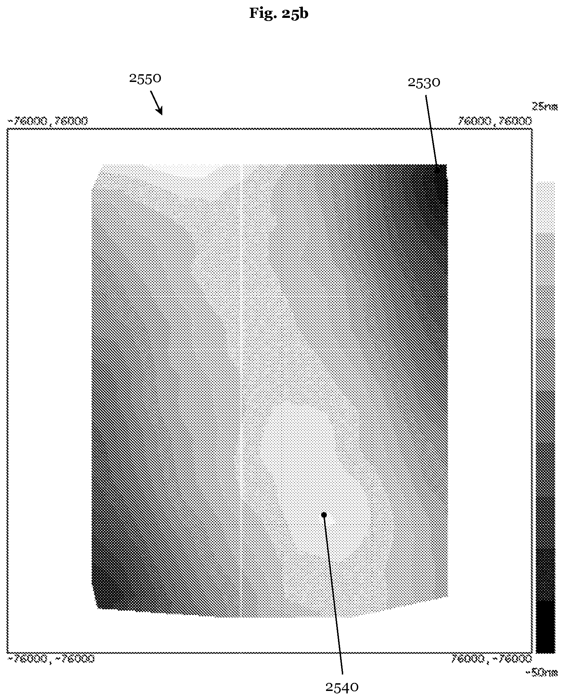

Diagram 2550 of Fig. 25b presents the induced mask surface contour deformation 2550 resulting from the registration correction process represented in Fig. 25a. The registration correction has been simulated under the constraints to simultaneously correct the surface contour deformation or the mask bending of the mask defined in Fig. 23a and 23b. The scale on the right side of Fig. 25b presents the range of the induced height variation which is 75 nm. The maximum height change induced by the specifically designed registration correction process is about 60 nm.

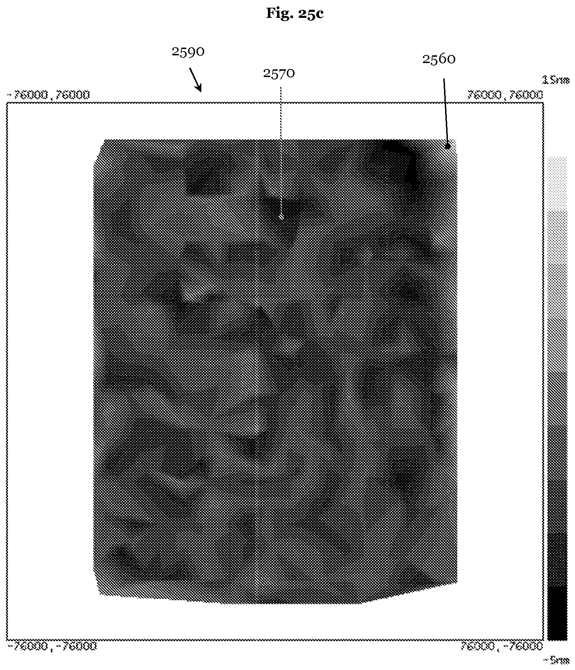

Diagram 2590 of Fig. 25c shows the resulting surface contour deformation or mask bending when adding the induced surface contour deformation as illustrated in Fig. 25b to the initial surface contour deformation presented in Fig. 23b. The overall scale of remaining surface contour deformation or the residual height variation of the hypothetic mask 2300 is 20 nm as represented by the scale on the right side of Fig. 25c. The maximum remaining height variation between the positions 2560 and 2570 is about 15 nm. This means that the mask 2300 corrected in a single correction step fulfils the error budgets of both registration and surface contour deformation.

The constraints of additionally correcting a surface contour deformation together with a registration defect slightly reduces the registration improvement from 89,2% to 84%. This reduction may be ignored, as it typically disappears in the metrology noise of the tool used to measure the registration defect.

However, the registration correction process having the additional constraints has an essential effect on the residual surface contour deformation. This is very positive, because even a mask having a surface contour deformation of more than 60 nm can be corrected in a single correction step. As a consequence, by monitoring the induced surface contour deformation, the error budget for an allowed surface contour deformation may be relaxed significantly.

The present application demonstrates that the determination of surface contour deformations may complement or substitute birefringence measurements for the determination of tool specific ES parameters. Further, the determination of surface contour deformations may provide an effective method of process control. Moreover, the determination of surface contour deformations enables establishing of a reliable process feedback.

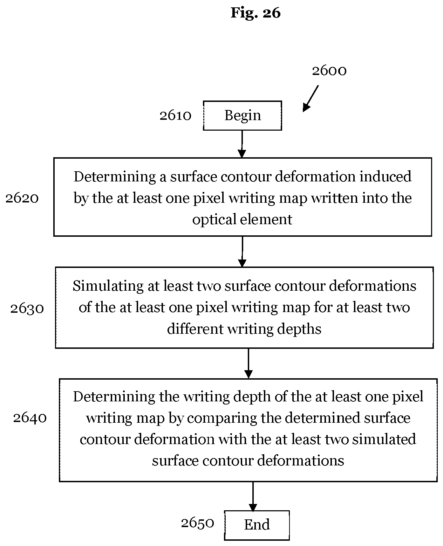

Fig. 26 shows a flow chart 2600 of the method for determining a writing depth 650, 2150 of a least one pixel writing map 610, 1510, 1710, 1910 written into an optical element 110, 500, 600, 2100 used in a lithographic process from a surface contour deformation of the optical element 110, 500, 600, 2100. The method begins at 2610. At step 2620, a surface contour deformation is determined which is induced by the at least one pixel writing map 610, 1510, 1710, 1910 written into the optical element 110, 500, 600, 2100. For example, the surface contour deformation may be determined by using the confocal microscope 100.

At step 2630, at least two surface contour deformations of the at least one pixel writing map 610, 1510, 1710, 1910 are simulated for at least two different writing depths 650, 2150. This step may be performed by the computer 170 of the confocal microscope 100, the computer 260 of the pixel writing tool 200 and/or the computing unit 360 of the apparatus 300.

At step 2640, the writing depth 650, 2150 of the at least one pixel writing map 610, 1510, 1710, 1910 is determined by comparing the determined surface contour deformation with the at least two simulated surface contour deformations. This step may also be performed by the computer 170 of the confocal microscope 100, the computer 260 of the pixel writing tool 200 and/or the computing unit 360 of the apparatus 300. Then the method ends at 2650.

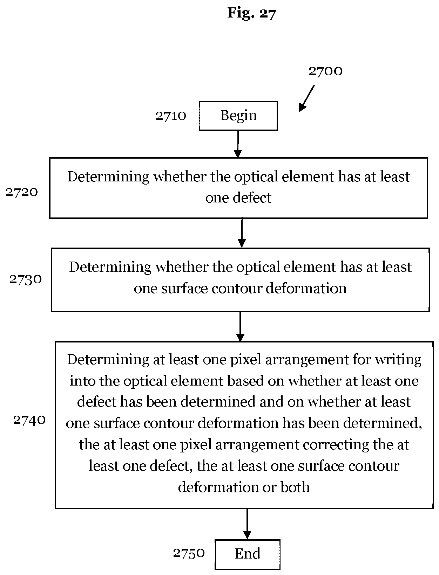

Finally, Fig. 27 presents a flow diagram 2700 of the method for optimizing a defect correction of an optical element 110, 500, 600, 2100 used in a lithographic process. The method begins at 2710. At step 2720, it is determined whether the optical element 110, 500, 600, 2100 has at least one defect 590. The at least one defect 590 may be determined by a registration metrology tool and/or an overlay metrology tool.

At step 2730, it is determined whether the optical element 110, 500, 600, 2100 has at least one surface contour deformation 530. For example, the confocal microscope 100 may be used to determine whether the optical element 110, 500, 600, 2100 has a surface contour deformation 530.

At step 2740, at least one pixel arrangement 2110 is determined for writing into the optical element 110, 500, 600, 2100 based on whether at least one defect 590 has been determined and whether at least one surface contour deformation 530 has been determined, wherein the at least on pixel arrangement 2110 corrects the at least one defect 590, the at least one surface contour deformation 530 or both. This step may also be performed by the computer 170 of the confocal microscope 100, the computer 260 of the pixel writing tool 200 and/or the computing unit 360 of the apparatus 300. Then the method ends at 2750.

## Claims

1. A method (2600) for determining a writing depth (650, 2150) of at least one pixel writing map (610, 1510, 1710, 1910) written into an optical element (110, 500, 600, 2100) used in a lithographic process from a surface contour deformation (1000, 2230) of the optical element (110, 500, 600, 2100), the method comprising the steps:
a. determining a surface contour deformation (1000, 2230) induced by the at least one pixel writing map (610, 1510, 1710, 1910) written into the optical element (110, 500, 600, 2100);
b. simulating at least two surface contour deformations of the at least one pixel writing map (610, 1510, 1710, 1910) for at least two different writing depths (650, 2150), and
c. determining the writing depth (650, 2150) of the at least one pixel writing map (610, 1510, 1710, 1910) by comparing the determined surface contour deformation (1000, 2230) with the at least two simulated surface contour deformations (2200).

2. The method (2600) of the preceding claim, wherein determining the surface contour deformation (1000, 2230) comprises:
(i) determining a surface contour of an initial optical element (110, 500, 600, 2100),
(ii) writing the at least one pixel writing map (610, 1510, 1710, 1910) into the optical element (110, 500, 600, 2100),
(iii) determining a final surface contour after writing the at least one pixel writing map (610, 1510, 1710, 1910), and
(iv) determining the surface contour deformation (1000, 2230) by comparing the initial surface contour with the final surface contour.

3. The method (2600) of any one of the preceding claims, wherein the at least one pixel writing map (610, 1510, 1710, 1910) is adapted to an expected writing depth (650, 2150) of the pixel writing map (610, 1510, 1710, 1910).

4. The method (2600) of any one of the preceding claims, wherein simulating the surface contour deformation (2200) comprises using a three-dimensional deformation model (350) of the optical element (110, 500, 600, 2100).

5. The method (2600) of any one of the preceding claims, wherein step c. further comprises: determining tool specific parameters of a three-dimensional deformation model (350) and the writing depth (650, 2150) of the at least one pixel writing map (610, 1510, 1710, 2100) in a common fitting process.

6. A method (2700) for optimizing a defect correction of an optical element (110, 500, 600, 2100) used in a lithographic process, the method comprising the steps:
a. determining whether the optical element (110, 500, 600, 2100) has at least one defect (590);
b. determining whether the optical element (110, 500, 600, 2100) has at least one surface contour deformation (530); and
c. determining at least one pixel arrangement (2110) for writing into the optical element (110, 500, 600, 2100) based on whether at least one defect (590) has been determined and on whether at least one surface contour deformation (530) has been determined, the at least one pixel arrangement (2110) correcting the at least one defect (590), the at least one surface contour deformation (530) or both, wherein determining the at least one pixel arrangement (2110) comprises determining a writing depth (650, 2150) of the at least one pixel arrangement (2110).

7. The method (2700) of the preceding claim, further comprising the step of writing the at least one pixel arrangement (2110) into the optical element (110, 500, 600, 2100).

8. The method (2700) of claim 6 or 7, wherein writing the at least one pixel arrangement (2110) comprises at least one of:
(i) correcting the at least one defect (590) without introducing a surface contour deviation, if at least one defect (590) is determined in step a. and if no surface contour deformation (530) is determined in step b.,
(ii) correcting the at least one surface contour deformation (530), if at least one surface contour deformation (530) is determined in step b. and if no defect is determined in step a., and
(iii) simultaneously correcting the at least one defect (590) and the at least one surface contour deformation (530), if at least one defect (590) is determined in step a. and at least one surface contour deformation (530) is determined in step b.

9. The method (2700) of any one of claims 6-8, wherein
(i) step a. comprises measuring data of the at least one defect (590) and/or obtaining data of the at least one defect (590), and/or
(ii) step b. comprises measuring data for determining the at least one surface contour deformation (530), and/or obtaining data for determining the at least one surface contour deformation (530).

10. The method (2700) of any one of claims 6-9, wherein the at least one pixel arrangement (2110) comprises at least two pixel layers written into different depths (650, 2150).

11. An optical element (110, 500, 600, 2100) manufactured according to a method of any one of the claims 6 to 10.

12. An apparatus (100, 300) for determining a writing depth (650, 2150) of at least one pixel writing map (610, 1510, 1710, 1910) written into an optical element (110, 500, 600, 2100) used in a lithographic process from a surface contour deformation (1000, 2230) of the optical element (110, 500, 600, 2100), comprising:
a. means for determining (100) a surface contour deformation (1000, 2230) induced by the at least one pixel writing map (610, 1510, 1710, 1910) written into the optical element (110, 500, 600, 2100);
b. means for simulating (170, 260, 360) at least two surface contour deformations (2200) of the pixel writing map (610, 1510, 1710, 1910) for at least two different writing depths (650, 2150), and
c. means for determining (170, 260, 360) the writing depth (650, 2150) of the at least one pixel writing map (610, 1510, 1710, 1910) by comparing the determined surface contour deformation (1000, 2230) with the at least two simulated surface contour deformations (2200).

13. An apparatus (400) for optimizing a defect correction of an optical element (110, 500, 600, 2100) used in a lithographic process, comprising:
a. means for determining (450) whether the optical element (110, 500, 600, 2100) has at least one defect (590);
b. means for determining (100, 300) whether the optical element (110, 500, 600, 2100) has at least one surface contour deformation (530); and
c. means for determining (170, 260, 360) at least one pixel arrangement (2110) for writing into the optical element (110, 500, 600, 2100) based on whether at least one defect (590) has been determined and on whether at least one surface contour deformation (530) has been determined, the at least one pixel arrangement (2110) correcting the at least one defect (590), the at least one surface contour deformation (530) or both, , wherein the means for determining the at least one pixel arrangement (2110) comprises means for determining a writing depth (650, 2150) of the at least one pixel arrangement (2110).

14. A computer program having instructions for causing a computer system (170, 260, 360) to perform any of the method steps of claims 6 to 10 when the computer system (170, 260, 360) executes the computer program.

## Patentansprüche

1. Verfahren (2600) zum Bestimmen einer Schreibtiefe (650, 2150) mindestens einer Pixelschreibkarte (610, 1510, 1710, 1910), die in ein optisches Element (110, 500, 600, 2100) geschrieben ist, das in einem lithographischen Prozess verwendet wird, anhand einer Oberflächenkonturverformung (1000, 2230) des optischen Elements (110, 500, 600, 2100), wobei das Verfahren die Schritte umfasst:
a. Bestimmen einer Oberflächenkonturverformung (1000, 2230), die durch die mindestens eine Pixelschreibkarte (610, 1510, 1710, 1910) induziert wird, die in das optische Element (110, 500, 600, 2100) geschrieben ist;
b. Simulieren von mindestens zwei Oberflächenkonturverformungen der mindestens einen Pixelschreibkarte (610, 1510, 1710, 1910) für mindestens zwei unterschiedliche Schreibtiefen (650, 2150), und
c. Bestimmen der Schreibtiefe (650, 2150) der mindestens einen Pixelschreibkarte (610, 1510, 1710, 1910) durch Vergleichen der bestimmten Oberflächenkonturverformung (1000, 2230) mit den mindestens zwei simulierten Oberflächenkonturverformungen (2200).

2. Verfahren (2600) nach dem vorhergehenden Anspruch, wobei das Bestimmen der Oberflächenkonturverformung (1000, 2230) umfasst:
(i) Bestimmen einer Oberflächenkontur eines anfänglichen optischen Elements (110, 500, 600, 2100),
(ii) Schreiben der mindestens einen Pixelschreibkarte (610, 1510, 1710, 1910) in das optische Element (110, 500, 600, 2100),
(iii) Bestimmen einer endgültigen Oberflächenkontur nach dem Schreiben der mindestens einen Pixelschreibkarte (610, 1510, 1710, 1910), und
(iv) Bestimmen der Oberflächenkonturverformung (1000, 2230) durch Vergleichen der anfänglichen Oberflächenkontur mit der endgültigen Oberflächenkontur.

3. Verfahren (2600) nach einem der vorhergehenden Ansprüche, wobei die mindestens eine Pixelschreibkarte (610, 1510, 1710, 1910) an eine erwartete Schreibtiefe (650, 2150) der Pixelschreibkarte (610, 1510, 1710, 1910) angepasst ist.

4. Verfahren (2600) nach einem der vorhergehenden Ansprüche, wobei das Simulieren der Oberflächenkonturverformung (2200) das Verwenden eines dreidimensionalen Verformungsmodells (350) des optischen Elements (110, 500, 600, 2100) umfasst.

5. Verfahren (2600) nach einem der vorhergehenden Ansprüche, wobei Schritt c. ferner umfasst: Bestimmen werkzeugspezifischer Parameter eines dreidimensionalen Verformungsmodells (350) und der Schreibtiefe (650, 2150) der mindestens einen Pixelschreibkarte (610, 1510, 1710, 2100) in einem gemeinsamen Anpassungsprozess.

6. Verfahren (2700) zum Optimieren einer Fehlerkorrektur eines optischen Elements (110, 500, 600, 2100), das in einem lithographischen Prozess verwendet wird, wobei das Verfahren die Schritte umfasst:
a. Bestimmen, ob das optische Element (110, 500, 600, 2100) mindestens einen Defekt (590) aufweist;
b. Bestimmen, ob das optische Element (110, 500, 600, 2100) mindestens eine Oberflächenkonturverformung (530) aufweist; und
c. Bestimmen mindestens einer Pixelanordnung (2110) zum Schreiben in das optische Element (110, 500, 600, 2100) basierend darauf, ob mindestens ein Defekt (590) bestimmt wurde und darauf, ob mindestens eine Oberflächenkonturverformung (530) bestimmt wurde, wobei die mindestens eine Pixelanordnung (2110) den mindestens einen Defekt (590), die mindestens eine Oberflächenkonturverformung (530) oder beide korrigiert, wobei das Bestimmen der mindestens einen Pixelanordnung (2110) das Bestimmen einer Schreibtiefe (650, 2150) der mindestens einen Pixelanordnung (2110) umfasst.

7. Verfahren (2700) nach dem vorhergehenden Anspruch, das ferner den Schritt des Schreibens der mindestens einen Pixelanordnung (2110) in das optische Element (110, 500, 600, 2100) umfasst.

8. Verfahren (2700) nach Anspruch 6 oder 7, wobei das Schreiben der mindestens einen Pixelanordnung (2110) mindestens eines von Folgendem umfasst:
(i) Korrigieren des mindestens einen Defekts (590) ohne Einbringen einer Oberflächenkonturabweichung, wenn mindestens ein Defekt (590) in Schritt a. bestimmt wird und wenn in Schritt b. keine Oberflächenkonturverformung (530) bestimmt wird,
(ii) Korrigieren der mindestens einen Oberflächenkonturverformung (530), wenn in Schritt b. mindestens eine Oberflächenkonturverformung (530) bestimmt wird und wenn in Schritt a. kein Defekt bestimmt wird, und
(iii) gleichzeitiges Korrigieren des mindestens einen Defekts (590) und der mindestens einen Oberflächenkonturverformung (530), wenn in Schritt a. mindestens ein Defekt (590) bestimmt wird und in Schritt b. mindestens eine Oberflächenkonturverformung (530) bestimmt wird.

9. Verfahren (2700) nach einem der Ansprüche 6-8, wobei
(i) Schritt a. das Messen von Daten des mindestens einen Defekts (590) und/oder das Erhalten von Daten des mindestens einen Defekts (590) umfasst, und/oder
(ii) Schritt b. das Messen von Daten zum Bestimmen der mindestens einen Oberflächenkonturverformung (530) und/oder das Erhalten von Daten zum Bestimmen der mindestens einen Oberflächenkonturverformung (530) umfasst.

10. Verfahren (2700) nach einem der Ansprüche 6-9, wobei die mindestens eine Pixelanordnung (2110) mindestens zwei Pixelschichten umfasst, die in unterschiedliche Tiefen (650, 2150) geschrieben sind.

11. Optisches Element (110, 500, 600, 2100), das gemäß einem Verfahren nach einem der Ansprüche 6 bis 10 hergestellt ist.

12. Einrichtung (100, 300) zum Bestimmen einer Schreibtiefe (650, 2150) mindestens einer Pixelschreibkarte (610, 1510, 1710, 1910), die in ein optisches Element (110, 500, 600, 2100) geschrieben ist, das in einem lithographischen Prozess verwendet wird, anhand einer Oberflächenkonturverformung (1000, 2230) des optischen Elements (110, 500, 600, 2100), umfassend:
a. Mittel zum Bestimmen (100) einer Oberflächenkonturverformung (1000, 2230), die durch die mindestens eine Pixelschreibkarte (610, 1510, 1710, 1910) induziert wird, die in das optische Element (110, 500, 600, 2100) geschrieben ist;
b. Mittel zum Simulieren (170, 260, 360) von mindestens zwei Oberflächenkonturverformungen (2200) der Pixelschreibkarte (610, 1510, 1710, 1910) für mindestens zwei unterschiedliche Schreibtiefen (650, 2150), und
c. Mittel zum Bestimmen (170, 260, 360) der Schreibtiefe (650, 2150) der mindestens einen Pixelschreibkarte (610, 1510, 1710, 1910) durch Vergleichen der bestimmten Oberflächenkonturverformung (1000, 2230) mit den mindestens zwei simulierten Oberflächenkonturverformungen (2200).

13. Einrichtung (400) zum Optimieren einer Fehlerkorrektur eines optischen Elements (110, 500, 600, 2100), das in einem lithographischen Prozess verwendet wird, umfassend:
a. Mittel zum Bestimmen (450), ob das optische Element (110, 500, 600, 2100) mindestens einen Defekt (590) aufweist;
b. Mittel zum Bestimmen (100, 300), ob das optische Element (110, 500, 600, 2100) mindestens eine Oberflächenkonturverformung (530) aufweist; und
c. Mittel zum Bestimmen (170, 260, 360) mindestens einer Pixelanordnung (2110) zum Schreiben in das optische Element (110, 500, 600, 2100) basierend darauf, ob mindestens ein Defekt (590) bestimmt wurde und darauf, ob mindestens eine Oberflächenkonturverformung (530) bestimmt wurde, wobei die mindestens eine Pixelanordnung (2110) den mindestens einen Defekt (590), die mindestens eine Oberflächenkonturverformung (530) oder beide korrigiert, wobei das Mittel zum Bestimmen der mindestens einen Pixelanordnung (2110) Mittel zum Bestimmen einer Schreibtiefe (650, 2150) der mindestens einen Pixelanordnung (2110) umfasst.

14. Computerprogramm mit Anweisungen, um ein Computersystem (170, 260, 360) zu veranlassen, einen der Verfahrensschritte der Ansprüche 6 bis 10 durchzuführen, wenn das Computersystem (170, 260, 360) das Computerprogramm ausführt.

## Revendications

1. Procédé (2600) de détermination d'une profondeur d'écriture (650, 2150) d'au moins une carte d'écriture de pixels (610, 1510, 1710, 1910) écrite dans un élément optique (110, 500, 600, 2100) utilisé dans un processus lithographique à partir d'une déformation de contour de surface (1000, 2230) de l'élément optique (110, 500, 600, 2100), le procédé comprenant les étapes de :
a. détermination d'une déformation de contour de surface (1000, 2230) induite par l'au moins une carte d'écriture de pixels (610, 1510, 1710, 1910) écrite dans l'élément optique (110, 500, 600, 2100) ;
b. simulation d'au moins deux déformations de contour de surface de l'au moins une carte d'écriture de pixels (610, 1510, 1710, 1910) pour au moins deux profondeurs d'écriture différentes (650, 2150), et
c. détermination de la profondeur d'écriture (650, 2150) de l'au moins une carte d'écriture de pixels (610, 1510, 1710, 1910) en comparant la déformation de contour de surface (1000, 2230) déterminée avec les déformations de contour de surface (2200) simulées.

2. Procédé (2600) selon la revendication précédente, dans lequel la détermination de la déformation de contour de surface (1000, 2230) comprend :
(i) la détermination d'un contour de surface d'un élément optique initial (110, 500, 600, 2100),
(ii) l'écriture de l'au moins une carte d'écriture de pixels (610, 1510, 1710, 1910) dans l'élément optique (110, 500, 600, 2100),
(iii) la détermination d'un contour de surface final après écriture de l'au moins une carte d'écriture de pixels (610, 1510, 1710, 1910), et
(iv) la détermination de la déformation de contour de surface (1000, 2230) en comparant le contour de surface initial avec le contour de surface final.

3. Procédé (2600) selon l'une quelconque des revendications précédentes, dans lequel l'au moins une carte d'écriture de pixels (610, 1510, 1710, 1910) est adaptée à une profondeur d'écriture (650, 2150) attendue de la carte d'écriture de pixels (610, 1510, 1710, 1910).

4. Procédé (2600) selon l'une quelconque des revendications précédentes, dans lequel la simulation de la déformation de contour de surface (2200) comprend l'utilisation d'un modèle de déformation tridimensionnelle (350) de l'élément optique (110, 500, 600, 2100).

5. Procédé (2600) selon l'une quelconque des revendications précédentes, dans lequel l'étape c. comprend en outre : la détermination de paramètres spécifiques à l'outil d'un modèle de déformation tridimensionnel (350) et la profondeur d'écriture (650, 2150) de l'au moins une carte d'écriture de pixels (610, 1510, 1710, 2100) dans un processus d'ajustement commun.

6. Procédé (2700) d'optimisation d'une correction de défauts d'un élément optique (110, 500, 600, 2100) utilisé dans un processus lithographique, le procédé comprenant les étapes de :
a. détermination établissant si l'élément optique (110, 500, 600, 2100) présente au moins un défaut (590) ;
b. détermination établissant si l'élément optique (110, 500, 600, 2100) a au moins une déformation de contour de surface (530) ; et
c. détermination d'au moins un agencement de pixels (2110) pour écrire dans l'élément optique (110, 500, 600, 2100) en fonction de si au moins un défaut (590) a été déterminé ou non et de si au moins une déformation de contour de surface (530) a été déterminée ou non, l'au moins un agencement de pixels (2110) corrigeant l'au moins un défaut (590), l'au moins une déformation de contour de surface (530) ou les deux, la détermination de l'au moins un agencement de pixels (2110) comprenant la détermination d'une profondeur d'écriture (650, 2150) de l'au moins un agencement de pixels (2110).

7. Procédé (2700) selon la revendication précédente, comprenant en outre l'étape d'écriture de l'au moins un agencement de pixels (2110) dans l'élément optique (110, 500, 600, 2100).

8. Procédé (2700) selon la revendication 6 ou 7, dans lequel l'écriture de l'au moins un agencement de pixels (2110) comprend au moins l'un parmi :
(i) la correction de l'au moins un défaut (590) sans introduire de déviation de contour de surface, si au moins un défaut (590) est déterminé à l'étape a. et si aucune déformation de contour de surface (530) n'est déterminée à l'étape b.,
(ii) la correction de l'au moins une déformation de contour de surface (530), si au moins une déformation de contour de surface (530) est déterminée à l'étape b. et si aucun défaut n'est déterminé à l'étape a., et
(iii) la correction simultanée de l'au moins un défaut (590) et de l'au moins une déformation de contour de surface (530), si au moins un défaut (590) est déterminé à l'étape a. et au moins une déformation de contour de surface (530) est déterminée à l'étape b.

9. Procédé (2700) selon l'une quelconque des revendications 6 à 8, dans lequel
(i) l'étape a. comprend la mesure de données de l'au moins un défaut (590) et/ou l'obtention de données de l'au moins un défaut (590), et/ou
(ii) l'étape b. comprend la mesure de données pour déterminer l'au moins une déformation de contour de surface (530), et/ou l'obtention de données pour déterminer l'au moins une déformation de contour de surface (530).

10. Procédé (2700) selon l'une quelconque des revendications 6 à 9, dans lequel l'au moins un agencement de pixels (2110) comprend au moins deux couches de pixels écrites dans des profondeurs différentes (650, 2150).

11. Élément optique (110, 500, 600, 2100) fabriqué selon un procédé selon l'une quelconque des revendications 6 à 10.

12. Appareil (100, 300) de détermination d'une profondeur d'écriture (650, 2150) d'au moins une carte d'écriture de pixels (610, 1510, 1710, 1910) écrite dans un élément optique (110, 500, 600, 2100) utilisé dans un processus lithographique à partir d'une déformation de contour de surface (1000, 2230) de l'élément optique (110, 500, 600, 2100), comprenant :
a. des moyens pour déterminer (100) une déformation de contour de surface (1000, 2230) induite par l'au moins une carte d'écriture de pixels (610, 1510, 1710, 1910) écrite dans l'élément optique (110, 500, 600, 2100) ;
b. des moyens pour simuler (170, 260, 360) au moins deux déformations de contour de surface (2200) de la carte d'écriture de pixels (610, 1510, 1710, 1910) pour au moins deux profondeurs d'écriture différentes (650, 2150), et
c. des moyens pour déterminer (170, 260, 360) la profondeur d'écriture (650, 2150) de l'au moins une carte d'écriture de pixels (610, 1510, 1710, 1910) en comparant la déformation de contour de surface (1000, 2230) déterminée avec les au moins deux déformations de contour de surface (2200) simulées.

13. Appareil (400) d'optimisation d'une correction de défauts d'un élément optique (110, 500, 600, 2100) utilisé dans un processus lithographique, comprenant :
a. des moyens pour déterminer (450) si l'élément optique (110, 500, 600, 2100) présente au moins un défaut (590) ;
b. des moyens pour déterminer (100, 300) si l'élément optique (110, 500, 600, 2100) a au moins une déformation de contour de surface (530) ; et
c. des moyens pour déterminer (170, 260, 360) au moins un agencement de pixels (2110) pour écrire dans l'élément optique (110, 500, 600, 2100) en fonction de si au moins un défaut (590) a été déterminé ou non et de si au moins une déformation de contour de surface (530) a été déterminée ou non, l'au moins un agencement de pixels (2110) corrigeant l'au moins un défaut (590), l'au moins une déformation de contour de surface (530) ou les deux, les moyens pour déterminer l'au moins un agencement de pixels (2110) comprenant des moyens pour déterminer une profondeur d'écriture (650, 2150) de l'au moins un agencement de pixels (2110).

14. Programme informatique ayant des instructions pour amener un système informatique (170, 260, 360) à réaliser l'une quelconque des étapes de procédé selon les revendications 6 à 10 lorsque le système informatique (170, 260, 360) exécute le programme informatique.
